# EUROPEAN PATENT APPLICATION

(11) **EP 4 835 957 A1**
(43) Date of publication of application: **04.11.2026**
(21) Application number: 24912278.9
(22) Date of filing: 05.12.2024
(51) Int. Cl.: H01L 21/60, H01L 21/304, H01L 21/677

(54) **PROCESSING SYSTEM AND PROCESSING METHOD**

(30) Priority: 28.12.2023 JP 2023223212
(71) Applicant: Tokyo Electron Limited, Tokyo 107-6325 (JP)
(72) Inventor: MINE, Yousuke, Kikuchi-gun, Kumamoto 869-1232 (JP)
(74) Representative: Hoffmann Eitle
(86) International application number: PCT/JP2024/043108
(87) International publication number: WO 2025/142388

(57) **Abstract**

A processing system for mounting dies of multiple types on a target substrate includes bonding apparatuses of multiple types each configured to bond a die held by a carrier to the target substrate. The bonding apparatuses of multiple types differ in accuracy of bonding of the dies with respect to the target substrate.

## Description

### TECHNICAL FIELD

The present disclosure relates to a processing system and a processing method.

### BACKGROUND ART

Patent Document 1 discloses a chip-on-wafer bonding method for mounting chips on a wafer. In this chip-on-wafer bonding method, a plurality of chips are bonded to a substrate after performing surface activation treatment and hydrophilization treatment of the chips and surface activation treatment and hydrophilization treatment of the substrate.

### RELATED ART DOCUMENTS

### PATENT DOCUMENT

Patent Document 1: Japanese Patent No. 6337400

### SUMMARY OF THE INVENTION

### PROBLEMS TO BE SOLVED BY THE INVENTION

With a technique according to the present disclosure, multiple types of dies can be efficiently mounted on a target substrate.

### MEANS FOR SOLVING THE PROBLEMS

One aspect of the present disclosure is a processing system for mounting dies of multiple types on a target substrate, the processing system including bonding apparatuses of multiple types each configured to bond a die held by a carrier to the target substrate. The bonding apparatuses of multiple types differ in accuracy of bonding of the dies with respect to the target substrate.

### EFFECTS OF THE INVENTION

According to the present disclosure, multiple types of dies can be efficiently mounted on a target substrate.

### BRIEF DESCRIPTION OF THE DRAWINGS

[FIG. 1] FIG. 1 is a plan view schematically illustrating a configuration of a wafer on which multiple types of dies are mounted.
[FIG. 2] FIG. 2 is a cross-sectional view schematically illustrating a configuration of a first carrier configured to hold first dies.
[FIG. 3] FIG. 3 is a plan view schematically illustrating the configuration of the first carrier configured to hold the first dies.
[FIG. 4] FIG. 4 is a cross-sectional view schematically illustrating a configuration of a second carrier configured to hold second dies.
[FIG. 5] FIG. 5 is a plan view schematically illustrating the configuration of the second carrier configured to hold the second dies.
[FIG. 6] FIG. 6 is a cross-sectional view schematically illustrating a configuration of a power supply and a static eliminator.
[FIG. 7] FIG. 7 is an explanatory view illustrating a state in which the first dies are electrostatically attracted to the first carrier.
[FIG. 8] FIG. 8 is a plan view illustrating a schematic configuration of a processing system.
[FIG. 9] FIG. 9 is a side view illustrating the schematic configuration of the processing system.
[FIG. 10] FIG. 10 is another side view illustrating the schematic configuration of the processing system.
[FIG. 11] FIG. 11 is a flow diagram illustrating main steps of a die-on-wafer manufacturing process.
[FIG. 12] FIG. 12 is an explanatory diagram schematically illustrating some of the steps of the die-on-wafer manufacturing process.
[FIG. 13] FIG. 13 is a perspective view schematically illustrating a configuration of a first bonding apparatus.
[FIG. 14] FIG. 14 is a cross-sectional view schematically illustrating a configuration of an air supply.
[FIG. 15] FIG. 15 is an explanatory diagram illustrating how the first die is separated from the first carrier.
[FIG. 16] FIG. 16 is a side view and a plan view schematically illustrating a configuration of a head unit.
[FIG. 17] FIG. 17 is an explanatory diagram schematically illustrating a part of a bonding process in the first bonding apparatus.
[FIG. 18] FIG. 18 is an explanatory view schematically illustrating another part of the bonding process in the first bonding apparatus.
[FIG. 19] FIG. 19 is an explanatory view schematically illustrating yet another step of the bonding process in the first bonding apparatus.
[FIG. 20] FIG. 20 is an explanatory view schematically illustrating yet another part of the bonding process in the first bonding apparatus.
[FIG. 21] FIG. 21 is an explanatory view schematically illustrating yet another step of the bonding process in the first bonding apparatus.
[FIG. 22] FIG. 22 is an explanatory view schematically illustrating yet another part of the bonding process in the first bonding apparatus.
[FIG. 23] FIG. 23 is a plan view schematically illustrating a configuration of a wafer on which multiple types of dies are mounted according to another embodiment.
[FIG. 24] FIG. 24 is a plan view schematically illustrating a configuration of a processing system according to another embodiment.
[FIG. 25] FIG. 25 is a perspective view schematically illustrating a configuration of a bonding apparatus according to another embodiment.
[FIG. 26] FIG. 26 is an explanatory view illustrating replacement of a bond head.

### DESCRIPTION OF EMBODIMENTS

In recent years, there has been a demand for semiconductor devices achieving higher performance and higher density, and a chip-on-wafer (CoW) manufacturing process has been considered as one type of three-dimensional mounting technology in response to such a demand. A chip-on-wafer is manufactured by a method disclosed in Patent Document 1 as an example.

In the chip-on-wafer manufacturing process (hereinafter referred to as "die-on-wafer manufacturing process"), as disclosed in Patent Document 1, semiconductor chips (hereinafter referred to as "dies") are surface-activated and hydrophilized, a semiconductor substrate (hereinafter referred to as a "wafer") is also surface-activated and hydrophilized, and then the dies are bonded to the wafer. The bonding of the plurality of dies to the wafer is performed, for example, by a bonding apparatus. In the bonding apparatus, the dies attracted to the tip (lower end) of a head unit and the wafer placed on a stage are arranged to face each other. Then, the head unit is lowered to place the dies on the wafer, thereby bonding the dies on the wafer.

In the die-on-wafer manufacturing process, multiple types of dies may be mounted on a wafer. There are various types of dies having different bonding accuracy requirements. For example, dies in which devices such as circuits are formed require high accuracy of bonding (hereinafter referred to as "high-accuracy dies"), whereas dies without such devices require lower accuracy of bonding (hereinafter referred to as "low-accuracy dies"). In this case, bonding high-accuracy dies to a wafer generally requires more time, whereas bonding low-accuracy dies can be performed more quickly. However, if a bonding apparatus with the same specifications is used for both high-accuracy and low-accuracy dies, the bonding of low-accuracy dies may also take longer than necessary, resulting in reduced throughput in the die-on-wafer manufacturing process. Accordingly, there remains room for improvement in techniques for mounting multiple types of dies on a wafer.

The technology according to the present disclosure can achieve efficient mounting of multiple types of dies on a target substrate. Hereinafter, a processing system and a processing method according to the present embodiment will be described with reference to the drawings. In the present specification and the drawings, elements having substantially the same functional configuration are denoted by the same reference numerals and redundant descriptions thereof will be omitted.

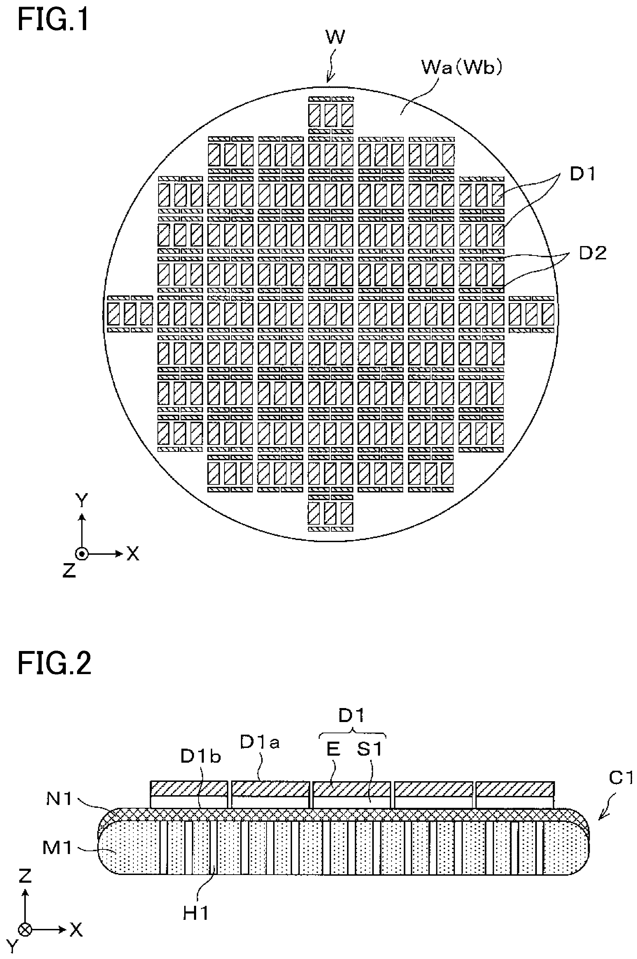

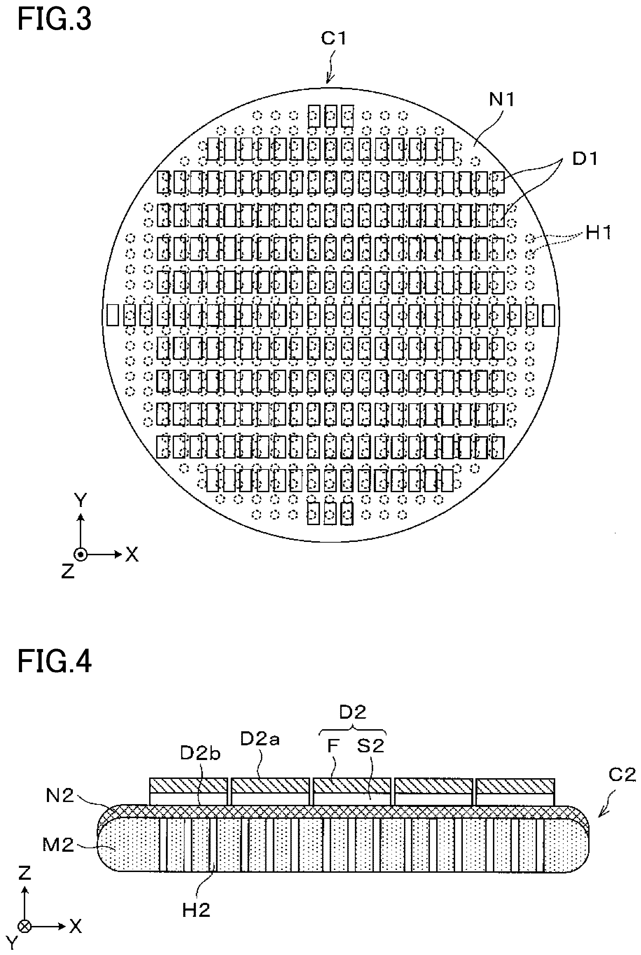

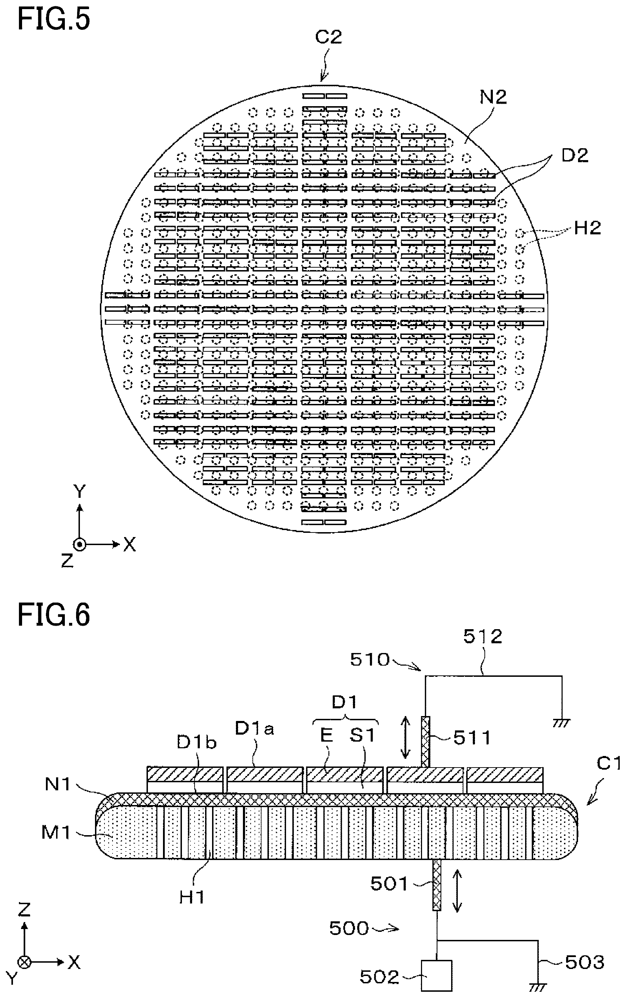

In the present embodiment, first dies D1 and second dies D2 of different types are mounted on a wafer W serving as a target substrate, as illustrated in FIG. 1. Specifically, a plurality of first dies D1 held by a first carrier C1 as illustrated in FIGS. 2 and 3 and a plurality of second dies D2 held by a second carrier C2 as illustrated in FIGS. 4 and 5 are bonded to a target wafer W.

As illustrated in FIG. 1, the wafer W on which the first dies D1 and the second dies D2 are mounted is a semiconductor wafer, such as a silicon substrate, or a glass substrate, which are used in a semiconductor device manufacturing process. For example, the wafer W has a diameter of 300 mm and a thickness of about 800 µm. In the wafer W, a surface on which the first dies D1 and the second dies D2 are mounted will be hereinafter called a "front surface Wa", and a surface opposite to the front surface Wa will be hereinafter called a "rear surface Wb".

The number and arrangement of the first dies D1 and the second dies D2 mounted on the front surface Wa of the wafer W are set to a desired pattern. A device layer (not illustrated) may be formed on the front surface Wa. Such a device layer is formed so as to correspond to a device layer E of the first die D1 described later.

As illustrated in FIGS. 2 and 3, the first carrier C1 holds a plurality of first dies D1. The first die D1 has a structure in which, for example, a silicon layer S1 and a device layer E are laminated. A circuit is formed in the device layer E. As will be described later, when the first dies D1 are bonded to the wafer W, the accuracy of bonding required by the first dies D1 is high; in other words, the first dies D1 are high-accuracy dies. In the first die D1, a surface on the side where the device layer E is formed is referred to as a "front surface D1a", and a surface on the side opposite to the front surface D1a is referred to as a "rear surface D1b".

As illustrated in FIGS. 4 and 5, the second carrier C2 holds a plurality of second dies D2. The second die D2 has a structure in which, for example, a silicon layer S2 and an oxide film F are laminated. No device such as a circuit is formed in the oxide film F. As will be described later, when the second dies D2 are bonded to the wafer W, the accuracy of bonding required by the second dies D2 is low; in other words, the second dies are low-accuracy dies. In the second die D2, a surface on which the oxide film F is formed is referred to as a "front surface D2a", and a surface on the side opposite to the front surface D2a is referred to as a "rear surface D2b".

As described above, the first die D1 and the second die D2 are of different types. A circuit is formed in the first die D1, whereas a circuit is not formed in the second die D2. Therefore, the accuracy of bonding required by the first die D1 is relatively high, and the accuracy of bonding required by the second die D2 is relatively low. In addition, the shape (size and thickness) of the first die D1 is different from the shape (size and thickness) of the second die D2. Therefore, the number of the first dies D1 held by the first carrier C1 is different from the number of the second dies D2 held by the second carrier C2.

The first carrier C1 and the second carrier C2 have similar structures. First, the structure of the first carrier C1 will be described.

As illustrated in FIGS. 2 and 3, the first carrier C1 has an attraction surface on its upper surface for holding a plurality of first dies D1 by electrostatic attraction and vacuum suction. The first carrier C1 attracts and holds the silicon layer S1 on the rear surface D1b side of the first die D1. The first carrier C1 has a structure in which a main body M1 and an insulating layer N1 are stacked. An electrode portion (electrode wiring pattern) configured to electrostatically attract the first dies D1 is not formed on the main body M1.

The main body M1 has substantially the same diameter and substantially the same thickness as the wafer W on which the first die D1 is mounted, for example, a diameter of 300 mm and a thickness of about 800 µm. The main body M1 is made of any material having conductivity, for example, silicon, aluminum, an aluminum alloy, stainless steel, alumina, zirconia, SiC, titanium, or the like. In other words, a silicon substrate may be used as the main body M1. The main body M1 may have substantially the same diameter as the wafer to be mounted on the first die D1 and a thickness different from that of the wafer (for example, 500 µm to 1,000 µm).

A plurality of through-holes H1 penetrating in the thickness direction are formed in the main body M1. The plurality of through-holes H1 may be formed at freely determined positions on the attraction surface of the first carrier C1. For example, the plurality of through-holes H1 may be formed in a one-to-one correspondence with the plurality of first dies D1 held on the first carrier C1; in other words, the number of through-holes H1 may be equal to the number of the first dies D1 held on the first carrier C1. For another example, the plurality of through-holes H1 may be formed in a one-to-many correspondence with the plurality of first dies D1 held on the first carrier C1; in other words, the number of through-holes H1 may be larger than the first dies D1 held on the first carrier C1.

The number, size, interval of formation and arrangement of the through-holes H1 are not particularly limited, but it is desirable to determine the number, size and interval of formation so as to ensure strength (rigidity) without causing deformation such as bending of the first carrier C1. For example, the diameter of the through-holes H1 is 0.5 mm to 5.0 mm, and the interval of formation (distance between centers of adjacent through-holes H1) is 0.5 mm to 5.0 mm.

The insulating layer N1 is formed on the surface of the main body M1, and constitutes an attraction surface of the first carrier C1 on which the first dies D1 are attracted. No through-holes are formed in the insulating layer N1, and the insulating layer N1 covers the surface of the main body M1. The insulating layer N1 has a thickness large enough to hold the first dies D1 on the first carrier C1 by electrostatic attraction, for example, several tens of micrometers.

The insulating layer N1 is made of a flexible and insulating material, such as polyimide or EVA (ethylene-vinyl acetate copolymer). In the present embodiment, "the insulating layer N1 has flexibility" means that the elastic modulus of the insulating layer N1 on the main body M1 is equal to or less than 2 GPa, preferably equal to or less than 0.5 GPa. In the present embodiment, the expression "the insulating layer N1 has insulation" means that the dielectric breakdown voltage of the insulating layer N1 on the main body M1 is equal to or greater than 30 kV, preferably equal to or greater than 40 kV.

As illustrated in FIGS. 4 and 5, the second carrier C2 has a structure similar to that of the first carrier C1, and has a structure in which a main body M2 and the insulating layer N2 are stacked. The structures of the main body M2 and the insulating layer N2 are similar to those of the main body M1 and the insulating layer N1, respectively. A plurality of through-holes H2 penetrating in the thickness direction are formed in the main body M2. Since the second dies D2 held by the second carrier C2 are of a type differing from that of the first dies D1, the number, size, interval, and arrangement of the through-holes H2 may be different from those of the through-holes H1 of the first carrier C1.

The first carrier C1 in the present embodiment is configured as described above, and electrostatically attracts and holds the first dies D1 to the attraction surface using Coulomb force generated between the first carrier C1 and the first dies D1. Similarly, the second carrier C2 electrostatically attracts and holds the second dies D2 on the attraction surface using Coulomb force generated between the second carrier C2 and the second dies D2.

A method for electrostatically attracting and holding the first dies D1 by the first carrier C1 will be described below; the method for electrostatically attracting and holding the second dies D2 with the second carrier C2 is similar. To attract and hold the first dies D1 by the first carrier C1 as illustrated in FIG. 6, a power supply 500 and a static eliminator 510 are used, for example,

The power supply 500 is arranged, for example, below the first carrier C1. The power supply 500 includes a power supply pin 501 configured to be brought into contact with the main body M1 to apply a voltage, a power supply source 502 configured to supply power to the power supply pin 501, and a ground wire 503. For example, the power supply pin 501 is configured to move up and down below the first carrier C1 and is brought into contact with the main body M1. The arrangement and configuration of the power supply 500 are not limited to the example described herein, and any arrangement and configuration may be adopted as long as a voltage can be appropriately applied to the first carrier C1.

The static eliminator 510 is arranged, for example, above the first carrier C1. The static eliminator 510 includes a static eliminator pin 511 configured to be brought into contact with the first die D1 on the first carrier C1 to discharge (ground) the first die D1, and a ground wire 512 connected to the static eliminator pin 511. For example, the static eliminator pin 511 is movably arranged above the first carrier C1, and can be grounded by being brought into contact with the first die D1 arranged at a freely determined position on the first carrier C1. The arrangement and configuration of the static eliminator 510 are not limited to the example described herein, and any arrangement and configuration may be adopted as long as the first dies D1 can be appropriately discharged.

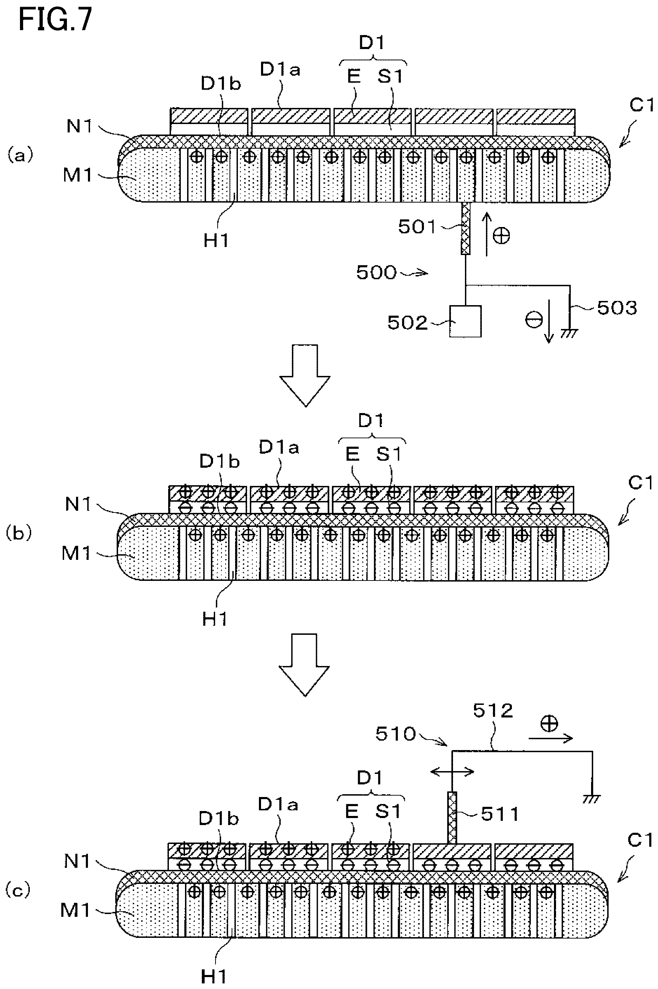

To electrostatically attract and hold the first dies by the first carrier C1, first, all the first dies D1 are arranged at the attraction holding positions of the first carrier C1 as illustrated in FIG. 7(a). Subsequently, a voltage (positive (+) charge in the illustrated example) is applied to the first carrier C1 via the power supply pin 501 of the power supply 500, and the main body M1 of the first carrier C1 is positively (+) charged.

When the main body M1 is positively (+) charged, charges of opposite polarity (i.e., negative (-)) to the charges accumulated in the main body M1 are accumulated on the rear surface D1b side of the first dies D1 across the insulating layer N1, as illustrated in FIG. 7(b). Furthermore, charges of the same polarity (i.e., positive (+)) as the charges accumulated in the main body M1 are accumulated on the front surface D1a side of the first dies D1.

Next, as illustrated in FIG. 7(c), the static eliminator pin 511 of the static eliminator 510 is brought into contact with the front surface D1a side (the opposite side of the rear surface D1b serving as the holding surface) of the first dies D1. Then, the positive charges on the front surface D1a side of the first dies D1 are discharged (grounded) while negative charges that attract the positive charges of the main body M1 remain.

Thereafter, when the static eliminator 510 is retracted, a potential difference is generated between the main body M1 of the first carrier C1 and the first dies D1 across the insulating layer N1, thereby generating electrostatic forces attracting each other, and the first dies D1 are attracted to the attraction surface of the first carrier C1 by electrostatic force.

As described above, in the present embodiment, the main body M1 of the first carrier C1 functions pseudo as a monopolar electrode, and the first dies D1 can be attracted to and held on the attraction surface via the insulating layer N1 without forming an electrode wiring pattern inside the main body M1. In other words, the insulating layer N1 insulates the charges applied to the main body M1, thereby maintaining the charges accumulated in the main body M1.

The insulating layer N1 of the first carrier C1 according to the present embodiment is formed of a flexible material having a small elastic modulus. After the first dies D1 are arranged on the first carrier C1 and before the first dies D1 are electrostatically attracted and held, a gap is formed between the first dies D1 and the insulating layer N1. Due to the flexibility of the insulating layer N1, when the first dies D1 are electrostatically attracted in the first carrier C1, air between the first dies D1 and the insulating layer N1 is expelled by the force pressing the first dies D1 against the insulating layer N1, thereby creating a quasi-vacuum state between the first dies D1 and the insulating layer N1. As a result, in addition to the electrostatic attraction force, a vacuum suction force generated by the quasi-vacuum state acts between the first carrier C1 and the first dies D1, thereby producing a strong holding state through the combined action of the electrostatic attraction force and the vacuum suction force.

The timing of applying a voltage to the main body M1 and the timing of discharging the first die D1 are not limited to the above-described examples. In other words, for example, a voltage may be applied to the main body M1 in advance before the first dies D1 are arranged on the attraction surface (in other words, in a state where the first dies D1 are not on the first carrier C1), or a voltage may be applied after the first dies D1 are arranged on the attraction surface (in other words, after all the first dies D1 are arranged on the first carrier C1) as illustrated in FIG. 7. A voltage may be applied to the main body M1 simultaneously with the arrangement of the first dies D1 on the attraction surface. The first dies D1 on the first carrier C1 may be discharged at the same time as the first dies D1 are arranged on the attraction surface and the voltage is applied, or may be discharged after the first dies D1 are arranged on the attraction surface and the first dies D1 are attracted and held by applying the voltage.

However, if a voltage is applied to the main body M1 in a state where the first dies D1 are not disposed on the attraction surface, particles may be attracted to the attraction surface by generated electrostatic force and may adhere to the attraction surface. In view of this, it is preferable to apply a voltage to the main body M1 after the first dies D1 are disposed on the attraction surface or at the same time as the first dies D1 are disposed on the attraction surface. It is more preferable to apply a voltage to the main body M1 after all the first dies D1 are disposed on the first carrier C1.

The manner in which the first dies D1 are held on the first carrier C1 is not limited to the present embodiment. For example, the first dies D1 may be pressed and bonded to the first carrier C1. In this case, when the first dies D1 are pressed against the first carrier C1, air between the first dies D1 and the insulating layer N1 is expelled, causing a vacuum suction force to act between the first dies D1 and the insulating layer N1, whereby the first dies D1 are electrostatically attracted and held by the first carrier C1. In this case, the material of the main body M1 of the first carrier C1 is not required to have conductivity and can be freely chosen. The material of the insulating layer N1 is also not required to have insulation and can be freely chosen.

For example, an adhesive sheet may be used for the insulating layer N1 of the first carrier C1. In this case, adhesive force is caused to act between the first dies D1 and the insulating layer N1, and the first dies D1 are held by the first carrier C1. A thermal release sheet may be used for the insulating layer N1. The thermal release sheet has adhesive force at normal temperature, but is released by heating. When the first dies D1 are bonded to the wafer W as described later, the first dies D1 are separated from the first carrier C1, and the insulating layer N1 can be heated to facilitate the separation of the first dies D1.

For example, intermolecular force, such as van der Waals force, may be generated between the insulating layer N1 of the first carrier C1 and the first dies D1, thereby causing the first dies D1 to be held on the first carrier C1. In this case, for example, the insulating layer N1 is heated to fluidize (glass transition), and then the first dies D1 are pressed against the insulating layer N1 for pressure-bonding, whereby the insulating layer N1 and the first dies D1 are brought into close contact. Although the method of heating the insulating layer N1 is freely chosen, for example, a heating mechanism may be provided on a stage (not illustrated) for holding the first carrier C1 to heat the insulating layer N1. This close contact causes intermolecular force to act between the insulating layer N1 and the first dies D1, whereby the first dies D1 are held by the first carrier C1. If intermolecular force is caused only by heating the insulating layer N1, the pressure-bonding of the first dies D1 to the insulating layer N1 may be omitted.

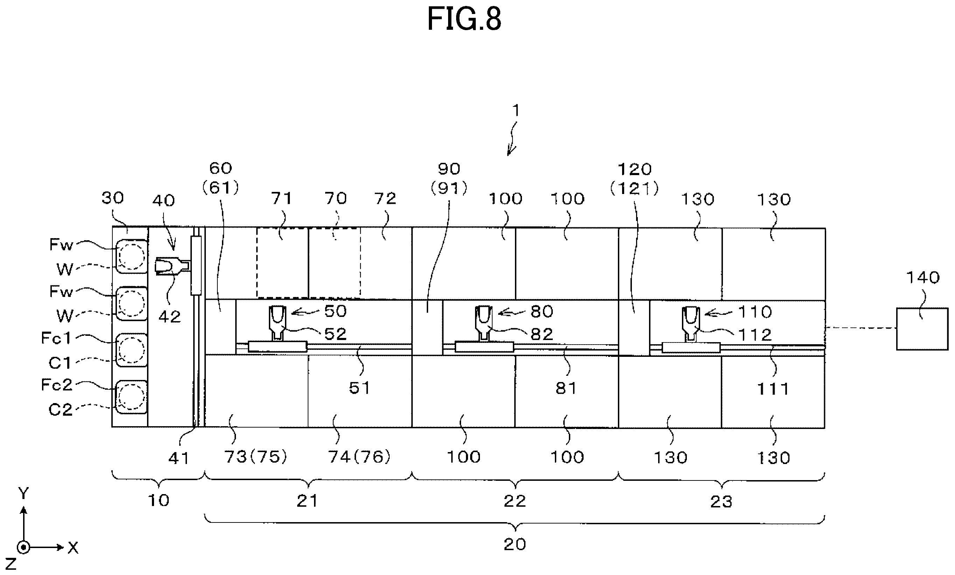

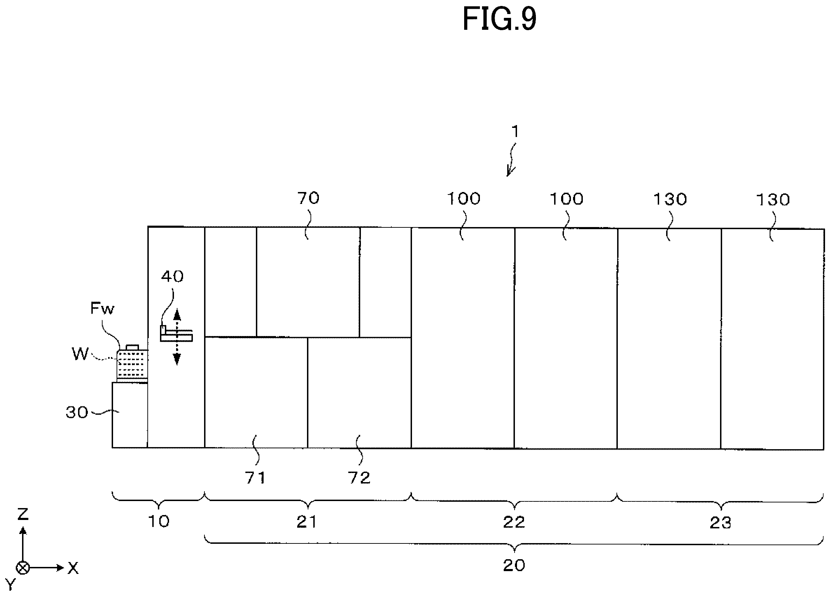

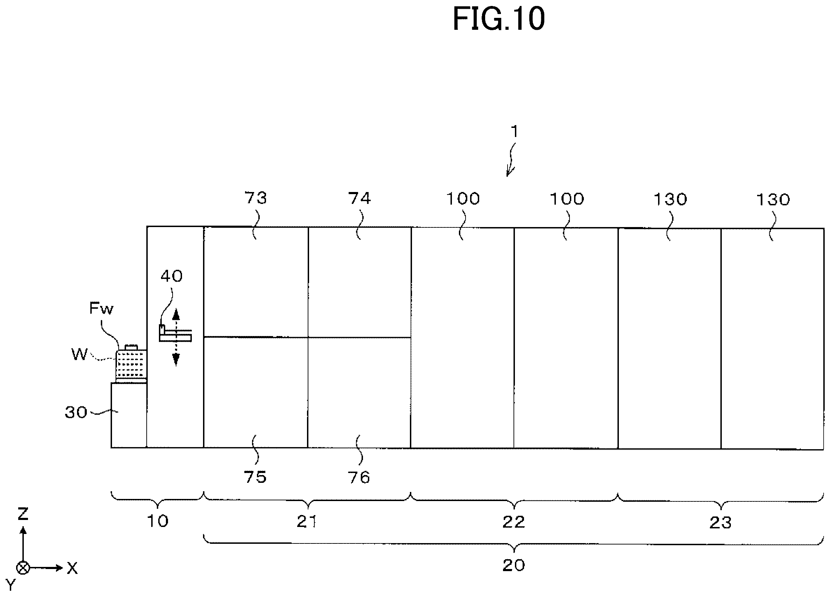

Next, a processing system 1 according to the present embodiment will be described. In the processing system 1, the plurality of first dies D1 held by the first carrier C1 and the plurality of second dies D2 held by the second carrier C2 are mounted on the wafer W. FIG. 8 is a plan view schematically illustrating the configuration of the processing system 1. FIGS. 9 and 10 are side views schematically illustrating the configuration of the processing system 1.

As illustrated in FIGS. 8 through 10, the processing system 1 has a configuration in which a loading and unloading station 10 and a processing station 20 are integrally connected. In the loading and unloading station 10, for example, hoops Fw, Fc1, and Fc2 configured to accommodate a plurality of wafers W, a plurality of first carriers C1, and a plurality of second carriers C2, respectively, are loaded and unloaded from and into the outside. The processing station 20 is provided with various processing apparatuses for realizing a series of processes described later.

The loading and unloading station 10 is provided with a hoop placement table 30. In the illustrated example, a plurality of hoops, for example, two hoops Fw, one hoop Fc1, and one hoop Fc2, are placed on the hoop placement table 30 in a row in the Y-axis direction. The number and arrangement of the hoops Fw, Fc1, and Fc2 placed on the hoop placement table 30 are not limited to the present embodiment and can be determined as appropriate.

On the positive X-axis direction side of the hoop placement table 30, a transfer device 40 is provided adjacent to the hoop placement table 30. The transfer device 40 is configured to move on a transfer path 41 extending in the Y-axis direction. The transfer device 40 includes, for example, a pair of transfer arms 42 configured to hold and transfer a wafer W, the first carrier C1, and the second carrier C2. Each of the transfer arms 42 is configured to move in the horizontal direction, the vertical direction, around the horizontal axis, and around the vertical axis. The configuration of the transfer arms 42 is not limited to the present embodiment, and any configuration may be adopted. The transfer device 40 is configured to transfer a wafer W, the first carrier C1, and the second carrier C2 to the hoops Fw, Fc1, and Fc2 of the hoop placement table 30, a transition device 60, which is described later, and a buffer device 61, which is also described later.

The processing station 20 is provided with, for example, three processing blocks 21 through 23. The first processing block 21, the second processing block 22, and the third processing block 23 are arranged in this order from the negative direction side of the X-axis to the positive direction side.

The first processing block 21 is provided with a transfer device 50, a transition device 60, a buffer device 61, an inspection device 70, a wafer surface modifying device 71 serving as a substrate surface modifying device, a die surface modifying device 72, a wafer surface cleaning device 73 serving as a substrate surface cleaning device, a die surface cleaning device 74, a wafer surface hydrophilizing device 75 serving as a substrate surface hydrophilizing device, and a die surface hydrophilizing device 76. The number and arrangement of these various processing apparatuses are not limited to the present embodiment and can be determined as appropriate.

The transfer device 50 is configured to move on a transfer path 51 extending in the X-axis direction. The transfer device 50 includes, for example, a pair of transfer arms 52 configured to hold and transfer the wafer W, and the first carrier C1 and the second carrier C2. The transfer arms 52 are configured to move in the horizontal direction, the vertical direction, around the horizontal axis and around the vertical axis, and are configured to transfer the wafer W, the first carrier C1, and the second carrier C2 to the devices 60, 61, and 70 through 76 of the first processing block 21, a transition device 90, which is described later, and a buffer device 91, which is also described later.

The transition device 60 and the buffer device 61 are arranged on the X-axis negative direction side of the transfer device 50. The transition device 60 and the buffer device 61 are arranged in a vertical stack in this order from top to bottom. A plurality of buffer devices 61 may be stacked.

The transition device 60 transfers the wafer W, the first carrier C1, and the second carrier C2 between the transfer device 40 and the transfer device 50. The buffer device 61 temporarily stores the wafer W, the first carrier C1, and the second carrier C2.

The inspection device 70, the wafer surface modifying device 71, and the die surface modifying device 72 are arranged on the Y-axis positive direction side of the transfer device 50. The inspection device 70, the wafer surface modifying device 71, and the die surface modifying device 72 are arranged in a vertical stack in this order from top to bottom. The wafer surface modifying device 71 and the die surface modifying device 72 are arranged in this order from the X-axis negative direction side to the positive direction side.

The inspection device 70 inspects the wafer W on which the first dies D1 and the second dies D2 are mounted. The inspection device 70 captures an image of the wafer W, for example, and inspects the presence or absence of voids between the surface Wa of the wafer W and the dies D1 and D2. The inspection device 70 may inspect the positions of the dies D1 and D2 bonded to the surface Wa of the wafer W.

The wafer surface modifying device 71 modifies the surface Wa of the wafer W using plasma. In the wafer surface modifying device 71, oxygen gas or nitrogen gas, which is a processing gas, is excited under, for example, a reduced pressure atmosphere, and plasma is formed and ionized. The surface Wa of the wafer W is irradiated with the oxygen ions or the nitrogen ions, and the surface Wa is plasma-treated and modified.

Similarly to the wafer surface modifying device 71, the die surface modifying device 72 modifies the surfaces D1a and D2a of the dies D1 and D2 using plasma. In the die surface modifying device 72, for example, oxygen gas or nitrogen gas, which is a processing gas, is excited under, for example, a reduced pressure atmosphere, and plasma is formed and ionized. The surfaces D1a and D2a of the dies D1 and D2 held by the carriers C1 and C2 are irradiated with the oxygen ions or the nitrogen ions, and the surfaces D1a and D2a are plasma-treated and modified.

The wafer surface cleaning device 73, the die surface cleaning device 74, the wafer surface hydrophilizing device 75, and the die surface hydrophilizing device 76 are arranged on the Y-axis negative direction side of the transfer device 50. The wafer surface cleaning device 73 and the die surface cleaning device 74, and the wafer surface hydrophilizing device 75 and the die surface hydrophilizing device 76 are arranged in a vertical stack in this order from top to bottom. The wafer surface cleaning device 73 and the die surface cleaning device 74 are arranged in this order from the X-axis negative direction side to the X-axis positive direction side. The wafer surface hydrophilizing device 75 and the die surface hydrophilizing device 76 are arranged in this order from the X-axis negative direction side to the X-axis positive direction side.

The wafer surface cleaning device 73 cleans the surface Wa of the wafer W. In the wafer surface cleaning device 73, for example, while the wafer W held by the spin chuck is rotated, a cleaning liquid, such as pure water, DI water, DHF, or IPA, is supplied onto the wafer W. The supplied cleaning liquid diffuses on the surface Wa of the wafer W, thereby cleaning the surface Wa.

Similarly to the wafer surface cleaning device 73, the die surface cleaning device 74 cleans the surfaces D1a and D2a of the dies D1 and D2. In the die surface cleaning device 74, a cleaning liquid is supplied onto the dies D1 and D2 held by the carriers C1 and C2, while the carriers C1 and C2 held by the chuck are rotated. The supplied cleaning liquid diffuses on the surfaces D1a and D2a of the dies D1 and D2, thereby cleaning the surfaces D1a and D2a.

The wafer surface hydrophilizing device 75 hydrophilizes and rinses the surface Wa of the wafer W. In the wafer surface hydrophilizing device 75, for example, pure water is supplied onto the wafer W, while the wafer W is held by the spin chuck is rotated. The supplied pure water diffuses onto the surface Wa of the wafer W, thereby hydrophilizing the surface Wa. Concurrently, the surface Wa is rinsed with the pure water.

Similarly to the wafer surface hydrophilizing device 75, the die surface hydrophilizing device 76 also hydrophilizes and rinses the surfaces D1a and D2a of the dies D1 and D2. In the die surface hydrophilizing device 76, for example, a cleaning liquid is supplied onto the dies D1 and D2 held by the carriers C1 and C2, while the carriers C1 and C2 held by the spin chucks are rotated. The supplied cleaning liquid diffuses onto the surfaces D1a and D2a of the dies D1 and D2, thereby hydrophilizing the surfaces D1a and D2a. Concurrently, the surfaces D1a and D2a are rinsed with the pure water.

The second processing block 22 is provided with a transfer device 80, a transition device 90, a buffer device 91, and a first bonding apparatus 100. The number and arrangement of these various processing devices are not limited to the present embodiment and can be determined as appropriate.

The transfer device 80 is configured to move on a transfer path 81 extending in the X-axis direction. The transfer device 80 includes, for example, a pair of transfer arms 82 configured to hold and transfer the wafer W, and the first carrier C1 and the second carrier C2. The transfer arms 82 are configured to move in the horizontal direction, the vertical direction, around the horizontal axis, and around the vertical axis, and are configured to transfer the wafer W, the first carrier C1, and the second carrier C2 to the devices 90, 91, and 100 of the second processing block 22, a transition device 120 described later, and a buffer device 121 described later.

The transition device 90 and the buffer device 91 are arranged on the X-axis negative direction side of the transfer device 80. The transition device 90 and the buffer device 91 are arranged in a vertical stack in this order from top to bottom. A plurality of buffer devices 91 may be stacked.

The transition device 90 transfers the wafer W, the first carrier C1, and the second carrier C2 between the transfer device 50 and the transfer device 80. The buffer device 91 temporarily stores the wafer W, the first carrier C1, and the second carrier C2.

For example, two of the first bonding apparatuses 100 are disposed in the positive Y-axis direction of the transfer device 80, and two are disposed in the negative Y-axis direction of the transfer device 80. The first bonding apparatus 100 bonds the first dies D1 (high-accuracy dies) held by the first carrier C1 to the wafer W. In other words, the accuracy of bonding required for the first bonding apparatus 100 is high (hereinafter, such a bonding apparatus may be referred to as a "high-accuracy bonding apparatus"). Details of the configuration of the first bonding apparatus 100 will be described later.

The third processing block 23 is provided with a transfer device 110, a transition device 120, a buffer device 121, and a second bonding apparatus 130. The number and arrangement of these various processing devices are not limited to the present embodiment and can be determined as appropriate.

The transfer device 110 is configured to move on a transfer path 111 extending in the X-axis direction. The transfer device 110 includes, for example, a pair of transfer arms 112 configured to hold and transfer the wafer W and the second carrier C2. Each transfer arm 112 is configured to move in the horizontal direction, the vertical direction, around the horizontal axis, and around the vertical axis, so that the wafer W and the second carrier C2 can be transferred to the respective devices 120, 121, and 130 of the third processing block 23.

The transition device 120 and the buffer device 121 are disposed on the negative X-axis direction side of the transfer device 110. The transition device 120 and the buffer device 121 are arranged in a vertical stack in this order from top to bottom. A plurality of buffer devices 121 may be stacked.

The transition device 120 transfers the wafer W and the second carrier C2 between the transfer device 80 and the transfer device 110. The buffer device 121 temporarily stores the wafer W, the first carrier C1, and the second carrier C2.

For example, two second bonding apparatuses 130 are arranged in the positive direction of the Y-axis of the transfer device 110, and two second bonding apparatuses 130 are arranged in the negative direction of the Y-axis of the transfer device 110. The second bonding apparatus 130 bonds the second dies D2 (low-accuracy dies) held by the second carrier C2 to the wafer W. In other words, the accuracy of bonding required for the second bonding apparatus 130 is low (hereinafter, such a bonding apparatus may be referred to as a "low-accuracy bonding apparatus"). Details of the configuration of the second bonding apparatus 130 will be described later.

The processing system 1 is provided with at least one control device 140. The control device 140 processes computer-executable instructions that cause the processing system 1 to perform various steps described in the present disclosure. The control device 140 may be configured to control elements of the processing system 1 to perform various steps described in the present disclosure. In one embodiment, a part or the entirety of the control device 140 may be included in the processing system 1. The control device 140 may include a processor, a storage, and a communication interface. The control device 140 may be implemented, for example, by a computer. The processor may be configured to perform various control operations by reading a program from the storage unit that provides logic or routines that enable various control operations to be performed and executing the read program. The program may be stored in advance in the storage or may be retrieved via a medium when necessary. The retrieved program is stored in the storage and read from the storage by the processor to be executed. The media may be various storage media readable by a computer or a communication line connected to a communication interface. The storage media may be temporary or non-temporary. The processing unit may be a CPU (central processing unit) or one or more circuits. The storage unit may include a RAM (random access memory), a ROM (read only memory), an HDD (hard disk drive), an SSD (solid state drive), or a combination thereof. The communication interface may communicate with the processing system 1 via a communication line such as a LAN (local area network).

Although the processing system 1 according to the present embodiment is configured as described above, other processing apparatuses may be further arranged in the processing system 1 according to purpose, and some processing apparatuses may be arranged outside the processing system 1 according to purpose.

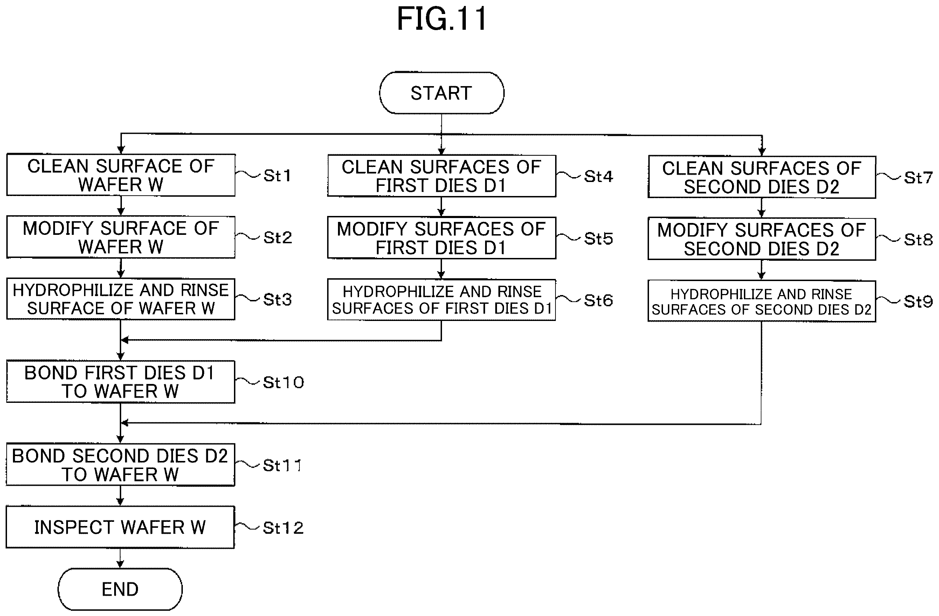

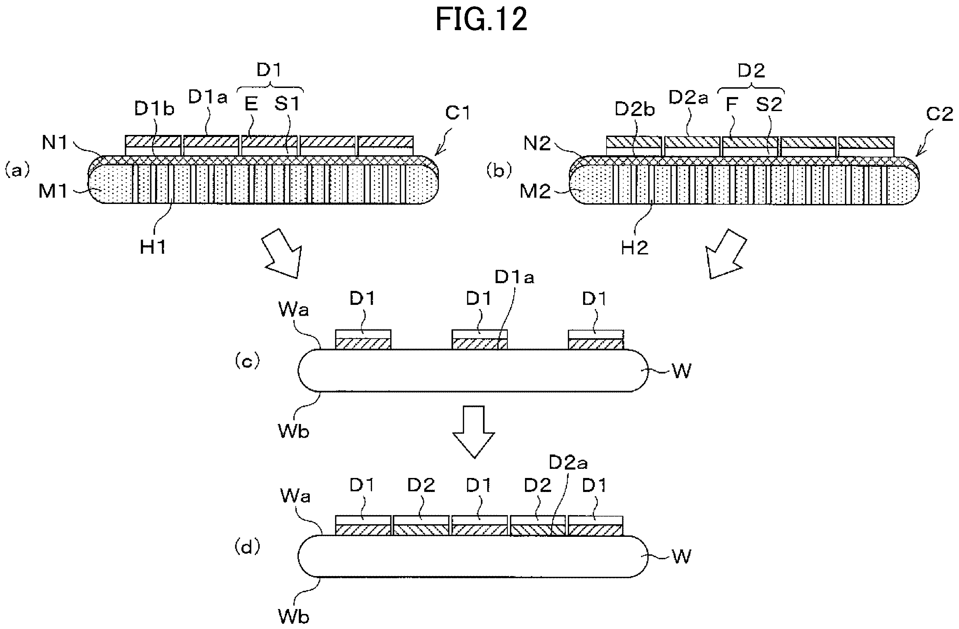

Next, a die-on-wafer manufacturing process performed in the processing system 1 configured as described above will be described. FIG. 11 is a flow diagram illustrating main steps of the die-on-wafer manufacturing process. FIG. 12 is an explanatory diagram schematically illustrating a part of steps of the die-on-wafer manufacturing process.

First, the hoops Fw, Fc1, and Fc2 accommodating a plurality of wafers W, a plurality of first carriers C1, and a plurality of second carriers C2, respectively, are mounted on the hoop placement table 30 of the loading and unloading station 10. At this time, a plurality of first dies D1 are held by the first carrier C1, as illustrated in FIG. 12(a), and a plurality of second dies D2 are held by the second carrier C2 as illustrated in FIG. 12(b). As described above, the first dies D1 are a high-accuracy die, and the second dies D2 are a low-accuracy die.

Next, the wafer W in the hoop Fw is taken out by the transfer device 40 and transferred to the transition device 60. The wafer W transferred to the transition device 60 is transferred to the wafer surface cleaning device 73 by the transfer device 50. In the wafer surface cleaning device 73, the surface Wa of the wafer W is cleaned with, for example, a cleaning liquid (step St1 in FIG. 11).

Next, the wafer W is transferred to the wafer surface modifying device 71 by the transfer device 50. In the wafer surface modifying device 71, plasma processing is performed under, for example, a reduced pressure atmosphere to modify the surface Wa of the wafer W (step St2 in FIG. 11).

Next, the wafer W is transferred to the wafer surface hydrophilizing device 75 by the transfer device 50. In the wafer surface hydrophilizing device 75, hydroxyl groups (silanol groups) adhere to the surface Wa of the wafer W modified in step St2 using, for example, pure water, and the surface Wa is hydrophilized. The surface Wa is rinsed with the pure water (step St3 in FIG. 11).

Next, the wafer W is transferred to the transition device 90 by the transfer device 50, and further transferred to the first bonding apparatus 100 by the transfer device 80. In the case where the four first bonding apparatuses 100 are busy performing the bonding process, the wafer W is transferred to the buffer device 91 and temporarily stored in the buffer device 91.

While the processing in steps St1 through St3 is performed on the wafer W, the processing of the first dies D1 held by the first carrier C1 is performed. First, the first carrier C1 in the hoop Fc1 is taken out by the transfer device 40 and transferred to the transition device 60. The first carrier C1 transferred to the transition device 60 is transferred to the die surface cleaning device 74 by the transfer device 50. In the die surface cleaning device 74, the surfaces D1a of the first dies D1 are cleaned with, for example, a cleaning liquid (step St4 in FIG. 11).

Next, the first carrier C1 is transferred to the die surface modifying device 72 by the transfer device 50. In the die surface modifying device 72, plasma treatment is performed under, for example, a reduced pressure atmosphere to modify the surfaces D1a of the first dies D1 (step St5 in FIG. 11).

Next, the first carrier C1 is transferred to the die surface hydrophilizing device 76 by the transfer device 50. In the die surface hydrophilizing device 76, hydroxyl groups (silanol groups) are attached to the surfaces D1a of the first dies D1 modified in step St5 using, for example, pure water to make the surfaces D1a hydrophilic. The surfaces D1a are rinsed with the purified water (step St6 in FIG. 11).

Next, the first carrier C1 is transferred to the transition device 90 by the transfer device 50, and further transferred to the first bonding apparatus 100 by the transfer device 80. When the four first bonding apparatuses 100 are busy performing the bonding process, the first carrier C1 is transferred to the buffer device 91 and temporarily stored in the buffer device 91.

While the wafer W is subjected to the above-described process in steps St1 through St3, and the first dies D1 are subjected to the above-described process in steps St4 through St6, the second dies D2 held by the second carrier C2 are subjected to the process. First, the second carrier C2 in the hoop Fc2 is taken out by the transfer device 40 and transferred to the transition device 60. The second carrier C2 transferred to the transition device 60 is transferred to the die surface cleaning device 74 by the transfer device 50. In the die surface cleaning device 74, the surfaces D2a of the second dies D2 are cleaned with, for example, a cleaning liquid (step St7 in FIG. 11).

Next, the second carrier C2 is transferred to the die surface modifying device 72 by the transfer device 50. In the die surface modifying device 72, plasma treatment is performed under, for example, a reduced pressure atmosphere to modify the surface D2a of the second dies D2 (step St8 in FIG. 11).

Next, the second carrier C2 is transferred to the die surface hydrophilizing device 76 by the transfer device 50. In the die surface hydrophilizing device 76, hydroxyl groups (silanol groups) are attached to the surfaces D2a of the second dies D2 modified in step St8 using, for example, pure water to hydrophilize the surfaces D2a. The surfaces D2a are rinsed with the pure water (step St9 in FIG. 11).

Next, the second carrier C2 is transferred to the transition device 90 by the transfer device 50, transferred to the transition device 120 by the transfer device 80, and further transferred to the second bonding apparatus 130 by the transfer device 110. When the four second bonding apparatuses 130 are busy performing the bonding process, the second carrier C2 is transferred to the buffer device 121 and temporarily stored in the buffer device 121.

As described above, the wafer W subjected to the above-described process in steps St1 through St3 is transferred to the first bonding apparatus 100, and the first carrier C1 subjected to the above-described process in steps St4 through St6 is transferred to the first bonding apparatus 100. In the first bonding apparatus 100, the first dies D1 held by the first carrier C1 are separated from the first carrier C1 and picked up. Thereafter, as illustrated in FIG. 12(c), the surfaces D1a of the picked-up first dies D1 are overlapped with the surface Wa of the wafer W, and the first dies D1 are pressed against the wafer W for bonding (step St10 in FIG. 11).

In step St10, since the surface Wa of the wafer W and the surfaces D1a of the first dies D1 are modified in steps St2 and St5, van der Waals forces (intermolecular forces) are generated between the surface Wa and the surfaces D1a, whereby the surface Wa and the surfaces D1a are bonded to each other. Furthermore, since the surface Wa of the wafer W and the surfaces D1a of the first dies D1 are made hydrophilic in steps St3 and St6, hydrophilic groups between the surface Wa and the surfaces D1a are hydrogen-bonded (intermolecular force), and the surface Wa and the surfaces D1a are firmly bonded to each other.

As described above, the first bonding apparatus 100 is a high-accuracy bonding apparatus. Since the first die D1 includes a device layer E on which a circuit or the like is formed and high accuracy of bonding is therefore required, the first dies D1 can be bonded at a desired position of the wafer W in step St10 with high accuracy.

When all the first dies D1 held by the first carrier C1 are bonded to the wafer W in step St10, the first carrier C1 is transferred to the transition device 90 by the transfer device 80, transferred to the transition device 60 by the transfer device 50, and further transferred to the hoop Fc1 by the transfer device 40. On the other hand, if any first die D1 remains on the first carrier C1 after step St10, the first carrier C1 may remain on the first bonding apparatus 100, and the remaining first dies D1 may be bonded to the subsequent wafer W. Alternatively, if any first die D1 remains on the first carrier C1 after step St10, the first carrier C1 may be transferred to the buffer device 91 by the transfer device 80 and temporarily stored in the buffer device 91.

On the other hand, if the first dies D1 are bonded to all desired positions of the wafer W in step St10, the wafer W is transferred to the transition device 120 by the transfer device 80 and further transferred to the second bonding apparatus 130 by the transfer device 110. When the four second bonding apparatuses 130 are busy performing the bonding process, the wafer W is transferred to the buffer device 121 and temporarily stored in the buffer device 121.

The second carrier C2 subjected to the above-described process in steps St7 through St9 is transferred to the second bonding apparatus 130. In the second bonding apparatus 130, the second dies D2 held by the second carrier C2 are separated from the second carrier C2 and picked up. Thereafter, as illustrated in FIG. 12(d), the surfaces D2a of the picked-up second dies D2 and the surface Wa of the wafer W are overlapped, and the second dies D2 are pressed against the wafer W for bonding (step St11 in FIG. 11).

In step St11, since the surface Wa of the wafer W and the surfaces D2a of the second dies D2 are modified in steps St2 and St8, respectively, van der Waals forces (intermolecular forces) are generated between the surface Wa and the surfaces D2a, and the surface Wa and the surfaces D2a are bonded to each other. Furthermore, since the surface Wa of the wafer W and the surfaces D2a of the second dies D2 are hydrophilized in steps St3 and St9, respectively, hydrophilic groups between the surfaces Wa and D2a are hydrogen-bonded (intermolecular forces), and the surface Wa and the surfaces D2a are firmly bonded to each other.

As described above, the second bonding apparatus 130 is a low-accuracy bonding apparatus. Since the second die D2 is not formed with a circuit or the like and the required accuracy of bonding is low, the second die D2 is bonded at a desired position of the wafer W in step St11 with low accuracy. In this case, since the accuracy of bonding is low, the time required for step St11 can be shortened.

When all the second dies D2 held by the second carriers C2 are bonded to the wafer W in step St11, the second carriers C2 are transferred to the transition device 120 by the transfer device 110, transferred to the transition device 90 by the transfer device 80, transferred to the transition device 60 by the transfer device 50, and further transferred to the hoop Fc2 by the transfer device 40. On the other hand, if any second die D2 remains on the second carrier C2 after step St11, the second carrier C2 may remain in the second bonding apparatus 130, and the remaining second dies D2 may be bonded to the subsequent wafer W. Alternatively, if any second die D2 remains on the second carrier C2 after step St11, the second carrier C2 may be transferred to the buffer device 121 by the transfer device 110 and temporarily stored in the buffer device 121.

On the other hand, when the second dies D2 are bonded respectively at all the desired positions of the wafer W in step St11 as illustrated in FIG. 1, the wafer W is transferred to the transition device 120 by the transfer device 110, transferred to the transition device 90 by the transfer device 80, and transferred to the inspection device 70 by the transfer device 50. In the inspection device 70, for example, an image of the wafer W is captured, and the presence or absence of voids between the surface Wa of the wafer W and the dies D1 and D2 is inspected (step St12 in FIG. 11).

Next, the wafer W is transferred to the transition device 60 by the transfer device 50, and further transferred to the hoop Fw by the transfer device 40. Thus, a series of die-on-wafer manufacturing processes is completed.

The hoops from which the wafers W, the first carriers C1, and the second carriers C2 are recovered, respectively, do not necessarily need to be the same hoops as those accommodating the wafers W, the first carriers C1, and the second carriers C2, respectively, at the time of loading. In other words, for example, the hoops accommodating the wafers W, the first carriers C1, and the second carriers C2, respectively, may unload different members, or new hoops or the like for unloading the wafers W, the first carriers C1, and the second carriers C2 may be loaded into the processing system 1.

According to the above embodiment, the processing system 1 includes the first bonding apparatus 100 serving as a high-accuracy bonding apparatus and the second bonding apparatus 130 serving as a low-accuracy bonding apparatus. When the first die D1 includes a device layer E on which a circuit or the like is formed and high accuracy of bonding is therefore required, the first die D1 can be bonded at a desired position of the wafer W with high accuracy in the first bonding apparatus 100. When the second die D2 has no circuit or the like formed and the required accuracy of bonding is therefore low, the second die D2 is bonded at a desired position of the wafer W with low accuracy in the second bonding apparatus 130. In this case, low accuracy of bonding is required, so that the time required for bonding the second dies D2 to the wafer W can be shortened. Therefore, while the first dies D1 and the second dies D2 of different types are appropriately mounted on the wafer W with required accuracy of bonding, the throughput of the die-on-wafer manufacturing process can be improved.

Herein, in the first bonding apparatus 100 and the second bonding apparatus 130, replacement of the bond head 261, described later, requires time, and calibration (correction) of the bond head 261 after replacement also requires additional time. In this regard, according to the present embodiment, since bonding of the first dies D1 and the second dies D2 having different sizes to the wafer W is performed by the first bonding apparatus 100 and the second bonding apparatus 130, respectively, replacement of the bond head 261 is unnecessary. Therefore, the time required for replacement of the bond head can be shortened, and the throughput of the die-on-wafer manufacturing process can be further improved.

In the present embodiment, the second bonding apparatus 130 is a low-accuracy bonding apparatus, and the configuration of the apparatus can be reduced to a low-accuracy specification as compared with a high-accuracy bonding apparatus, as will be described later. As a result, the apparatus cost of the second bonding apparatus 130 can be reduced, and the apparatus cost of the processing system 1 can be reduced.

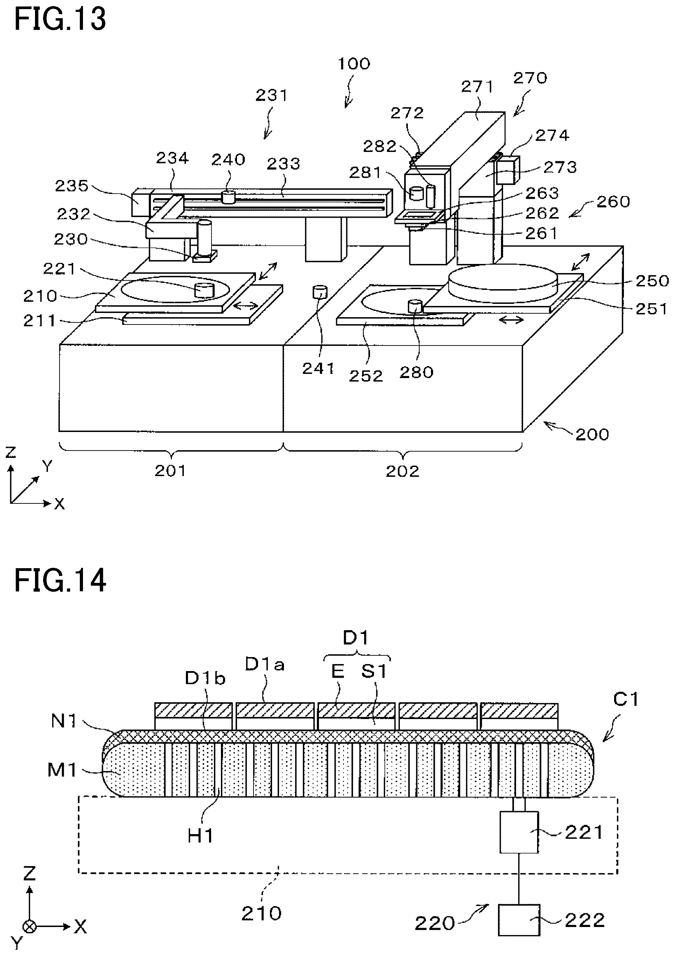

Next, the configurations of the first bonding apparatus 100 and the second bonding apparatus 130 described above will be described. The required accuracy of bonding differs between the first bonding apparatus 100 and the second bonding apparatus 130, and the configuration of the first bonding apparatus 100 will be described first, and then the configuration of the second bonding apparatus 130 will be described mainly with respect to differences from the first bonding apparatus 100. FIG. 13 is a perspective view schematically illustrating the configuration of the first bonding apparatus 100.

As illustrated in FIG. 13, the first bonding apparatus 100 includes a stage 200. The stage 200 is divided into a separation region 201 and a bonding region 202. The separation region 201 and the bonding region 202 are arranged side by side in the horizontal direction (the positive direction of the X-axis). In the separation region 201, the first die D1 held by the first carrier C1 is separated from the first carrier C1 and picked up. In the bonding region 202, the first die D1 picked up by the separation region 201 is bonded to the wafer W.

The separation region 201 is provided with a carrier holder 210. The carrier holder 210 has a holding surface of the first carrier C1 on its upper surface and holds the first carrier C1 holding the first dies D1 in a state where the surfaces D1a of the first dies D1 face upward.

A moving mechanism 211 is provided below the carrier holder 210. The moving mechanism 211 moves the carrier holder 210 in the horizontal direction (X-axis direction and Y-axis direction). The driving part of the moving mechanism 211 is not particularly limited, but for example, a linear motor is used.

As illustrated in FIG. 14, the carrier holder 210 is provided with an air supplier 220. The air supplier 220 includes an air cap 221 and an air supply 222. The air cap 221 is provided inside the carrier holder 210 and supplies air to the through-holes H1 of the first carrier C1 held by the carrier holder 210. The air supply 222 stores air inside itself and supplies air to the air cap 221.

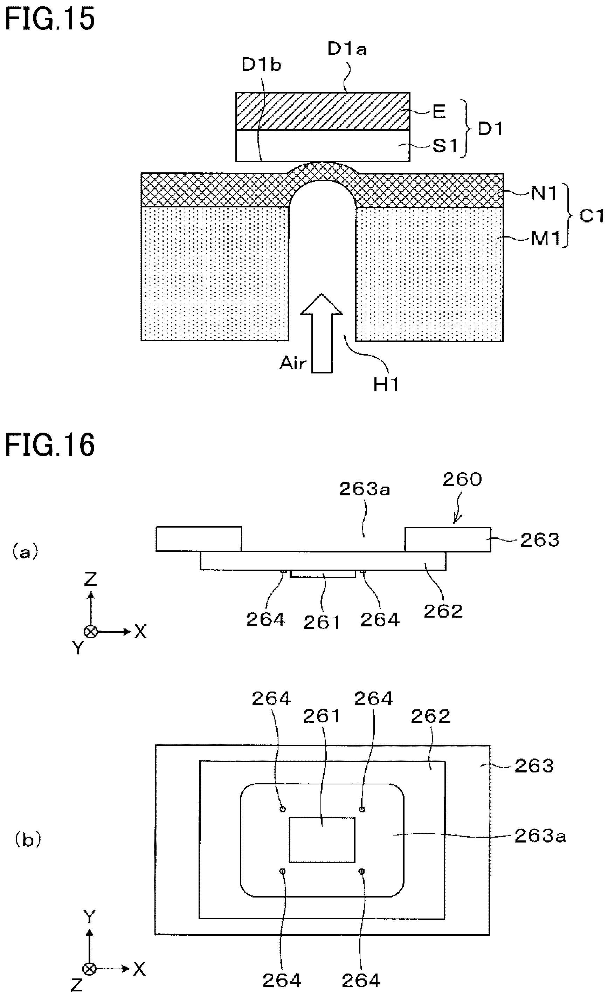

The air supplier 220 supplies air from the air cap 221 to the rear surface D1b side of the first die D1 on the first carrier C1 via the through-hole H1. As a result, pressure by air is applied to the first die D1, thereby reducing the adhesion between the first die D1 and the insulating layer N1 on the attraction surface of the first carrier C1. More specifically, as illustrated in FIG. 15, when air is supplied to the rear surface D1b side of the first die D1, the insulating layer N1 expands, forming a convex shape with the center portion of the through-hole H1 in the main body M1, located directly beneath the first die D1, acting as the apex. As a result, while the adhesion between the first die D1 and the insulating layer N1 is maintained at the center of the first die D1 corresponding to the center portion of the through-hole H1, the first die D1 is lifted up from the insulating layer N1 at the outer periphery of the first die D1 corresponding to the peripheral portion of the through-hole H1. As a result, the adhesion between the first die D1 and the insulating layer N1 is reduced, and the first die D1 can be separated from the attraction surface of the first carrier C1.

As illustrated in FIG. 13, a collet 230 is provided above the carrier holder 210. The collet 230 picks up and transfers the first die D1 from the first carrier C1. Specifically, the collet 230 holds the first die D1 whose outer periphery is lifted up due to a decrease in adhesion with the insulating layer N1 caused by the supply of air from the air supplier 220, separates the first die D1 from the first carrier C1, and transfers the held first die D1 from the separation region 201 to the bonding region 202.

The method of holding the first die D1 by the collet 230 can be freely chosen. However, since the surface D1a of the first die D1 held by the collet 230 is a device surface of the device layer E, it is necessary to hold the first die D1 by the collet 230 so as not to damage the device surface. For example, a non-contact chuck configured to hold the first die D1 from above in a non-contact manner by utilizing a Bernoulli effect or an ultrasonic squeeze effect may be used as the collet 230. Alternatively, instead of holding the surface D1a of the first die D1, the collet 230 may be configured to hold a side surface of the first die D1 lifted up by, for example, air supply.

The collet 230 is supported by a moving mechanism 231. The moving mechanism 231 supports and moves the collet 230. The moving mechanism 231 includes an arm 232, a rail 233, a support member 234, and a driving part 235. The distal end of the arm 232 supports the collet 230, and the proximal end is attached to the rail 233. The rail 233 extends in the X-axis direction and is supported by the support member 234. The driving part 235 moves the arm 232 and the collet 230 along the rail 233 in the X-axis direction. The driving part 235 also moves the arm 232 and the collet 230 in the Y-axis direction. Furthermore, the driving part 235 rotates the collet 230 supported by the arm 232 around the horizontal axis (around the X-axis), and the collet 230 can invert the front and rear surfaces of the first die D1 held. The driving source of the driving part 235 is not particularly limited, but for example, a linear motor is used.

A first imaging unit 240 is provided above the carrier holder 210. A camera, for example, is used for the first imaging unit 240. The first imaging unit 240 captures images of at least two points of the first die D1 on the first carrier C1 held by the carrier holder 210 from above. The first imaging unit 240 is fixed, and captures images of two points of the first die D1 by moving the carrier holder 210. The captured images are output to the control device 140, and the control device 140 measures the position of the first die D1 on the first carrier C1. The control device 140 controls the moving mechanism 231 based on the measured position of the first die D1, and adjusts the position of the collet 230 so that the collet 230 appropriately picks up the first die D1.

A second imaging unit 241 is provided below the collet 230 on the X-axis positive direction side of the carrier holder 210. For example, a camera is used as the second imaging unit 241. The second imaging unit 241 captures images of at least two points of the first die D1 held by the collet 230 from below. The second imaging unit 241 is fixed, and captures images of two points of the first die D1 by moving the collet 230. The captured images are output to the control device 140, and the control device 140 measures the position of the first die D1 held by the collet 230. The control device 140 controls the moving mechanism 231 based on the measured position of the first die D1 and adjusts the position of the collet 230, so that the collet 230 can transfer the first die D1 to an appropriate position of a bond head 261, which is described later.

The bonding region 202 is provided with a wafer holder 250 serving as a substrate holder. The wafer holder 250 has a holding surface of the wafer W on the upper surface, and holds the wafer W with the surface Wa, which is the mounting surface on which the first dies D1 are mounted, facing upward. The wafer holder 250 is supported by a support plate 251.

A moving mechanism 252 is provided below the support plate 251. The wafer holder 250 and the support plate 251 are configured to be movable in the horizontal direction (X-axis direction and Y-axis direction) by the moving mechanism 252. The driving part of the moving mechanism 252 is not particularly limited, but, for example, a linear motor is used.

A head unit 260 is provided above the wafer holder 250. The head unit 260 receives and holds the first die D1 from the collet 230, transfers the held first die D1 to the wafer W, and bonds the first die D1 to the wafer W. As illustrated in FIG. 16, the head unit 260 includes a bond head 261, a glass plate 262, and a base 263.

The bond head 261 receives and holds the first die D1 held by the collet 230 from above. The holding surface (lower surface) of the first die D1 in the bond head 261 has a convex shape with a central portion projecting downward.

The holding method of the first die D1 by the bond head 261 is freely chosen. Since the rear surface D1b of the first die D1 held by the bond head 261 is the silicon layer S1, the bond head 261 is not necessarily required to employ a non-contact chuck or similar mechanism, as is the case with the collet 230. For example, a vacuum chuck may be used for the bond head 261, and the bond head 261 may attract and hold the first die D1 by vacuum suction by a vacuum mechanism (not illustrated).

The glass plate 262 is larger than the bond head 261 and holds the entire upper surface of the bond head 261. The method of holding the bond head 261 by the glass plate 262 is optional. For example, the glass plate 262 may attract and hold the bond head 261 by vacuum suction by a vacuum mechanism (not illustrated). In this case, the bond head 261 is detachable from the glass plate 262 and the bond head 261 is replaceable.

The base 263 supports the outer periphery of the upper surface of the glass plate 262. The base 263 has an annular shape, and an opening 263a is formed in the center of the base 263. The opening 263a is formed to be at least larger than the bond head 261; in other words, the bond head 261 held by the glass plate 262 is arranged inside the opening 263a in a plan view.

A plurality of, for example, four alignment marks 264 are provided on the lower surface of the glass plate 262. The four alignment marks 264 are arranged outside the bond head 261 held by the glass plate 262 and inside the opening 263a in a plan view.

As illustrated in FIG. 13, a third imaging unit 280, which is described later, is provided below the head unit 260, and a fourth imaging unit 281, which is described later, and a fifth imaging unit 282, which is also described later, are provided above the head unit 260. Since the imaging units 280, 281, and 282 move minutely with time, alignment needs to be carried out at a desired timing. The alignment is carried out by capturing images of the four alignment marks 264 using the imaging units 280, 281, and 282. For this purpose, the glass plate 262 is made transparent.

The fourth imaging unit 281 and fifth imaging unit 282, which are described later, respectively capture images of the wafer W held by the wafer holder 250 below the head unit 260. The fourth imaging unit 281 and the fifth imaging unit 282 respectively capture images of the wafer W through the glass plate 262 outside the bond head 261 and inside the opening 263a in a plan view. For this purpose, the glass plate 262 is made transparent.

The head unit 260 is supported by a moving mechanism 270. The moving mechanism 270 supports and moves the head unit 260. The moving mechanism 270 includes an arm 271, a rail 272, a support member 273, and a driving part 274. The distal end of the arm 271 supports the base 263 of the head unit 260, and the proximal end is attached to a rail 272. The rail 272 extends in the X-axis direction and is supported by the support member 273. The driving part 274 moves the arm 271 and the head unit 260 along the rail 272 in the X-axis direction. The driving part 274 also moves the arm 271 and the head unit 260 in the Y-axis direction. Although the drive source of the driving part 274 is not particularly limited, a linear motor is used, for example.

The third imaging unit 280 is provided below the head unit 260. A camera, for example, is used as the third imaging unit 280. The third imaging unit 280 captures images of at least two points of the first die D1 held by the bond head 261 from below in a state where the wafer holder 250 is retracted to a position not overlapping the third imaging unit 280 in a plan view. The third imaging unit 280 is fixed, and captures images of two points of the first die D1 by moving the bond head 261. The captured images are output to the control device 140, and the control device 140 measures the position of the first die D1 held by the bond head 261.

The fourth imaging unit 281 is provided above the head unit 260, more specifically, above the opening 263a of the base 263. A camera, for example, is used for the fourth imaging unit 281. The fourth imaging unit 281 captures images of at least two points of the wafer W held by the wafer holder 250 from above. At least one of the fourth imaging unit 281 and the wafer holder 250 is moved to capture images of two points of the wafer W. The captured images are output to the control device 140, and the control device 140 measures the position of the wafer W held by the wafer W.

The control device 140 adjusts the position of the first die D1 relative to the wafer W based on the position of the first die D1 measured using the third imaging unit 280 and the position of the wafer W measured using the fourth imaging unit 281. Specifically, the control device 140 controls at least one of the moving mechanism 252 and the moving mechanism 270, moves at least one of the first die D1 and the wafer W, and adjusts the position of the first die D1 relative to the wafer W so that the first die D1 is bonded at an appropriate position relative to the wafer W.

The fifth imaging unit 282 is provided above the head unit 260, more specifically, above the opening 263a of the base 263. An IR camera, for example, is used for the fifth imaging unit 282. The fifth imaging unit 282 captures images of the first die D1 mounted on the wafer W from above. The captured images are output to the control device 140, and the control device 140 measures the position of the first die D1 relative to the wafer W. In other words, the control device 140 checks the accuracy of bonding of the first die D1 relative to the wafer W.

The fourth imaging unit 281 and the fifth imaging unit 282 may be supported by the arm 271 of the moving mechanism 270 via a support member (not illustrated) and may be configured to move in the horizontal direction (X-axis direction and Y-axis direction) by the moving mechanism 270. Alternatively, the fourth imaging unit 281 and the fifth imaging unit 282 may be supported by a moving mechanism (not illustrated) different from the moving mechanism 270 and may be configured to move in the horizontal direction (X-axis direction and Y-axis direction) by the moving mechanism.

Next, a method of bonding the first dies D1 to the wafer W using the first bonding apparatus 100 configured as described above will be described.

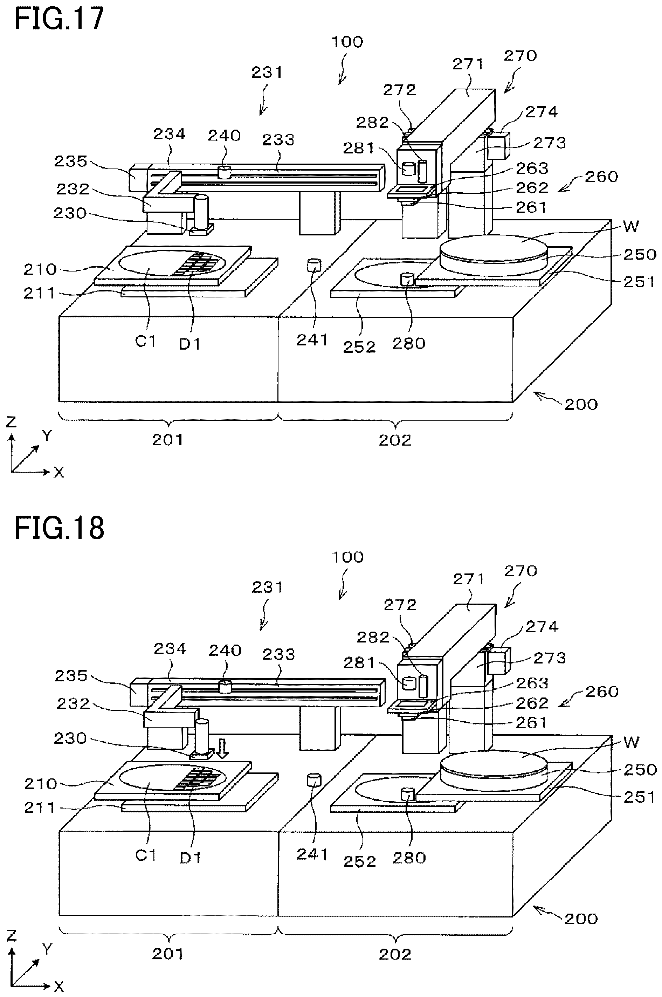

First, as illustrated in FIG. 17, the wafer W and the first carrier C1 holding a plurality of first dies D1 are transferred to the first bonding apparatus 100. The wafer W is held by the wafer holder 250 with the surface Wa facing upward. At this time, the wafer holder 250 is disposed at a position not overlapping the third imaging unit 280 in a plan view, i.e., on the positive X-axis side of the third imaging unit 280 in the illustrated example. The first carrier C1 is held by the carrier holder 210 with the surfaces D1a of the first dies D1 facing upward.

Next, the first imaging unit 240 captures images of at least two points of one of the first dies D1 to be bonded among the first dies D1 on the first carrier C1 held by the carrier holder 210. The captured images are output to the control device 140, and the control device 140 measures the position of the first die D1 on the first carrier C1. The control device 140 controls the moving mechanism 231 based on the measured position of the first die D1, moves the carrier holder 210, and adjusts the position of the collet 230 and the position of the first die D1 picked up by the collet 230.

Next, the air supplier 220 selectively supplies air to the through-hole H1 corresponding to the first die D1 to be bonded, and the insulating layer N1 is expanded, so that the first die D1 is pushed up from below and lifted up.

Next, the collet 230 is lowered as illustrated in FIG. 18, and the surface D1a of the lifted first die D1 is held by the collet 230. Alternatively, the first die D1 may be held by the collet 230 before the first die D1 is lifted up by air, or may be held at the same time as the first die D1 is lifted up by air. Subsequently, the collet 230 is lifted up to pick up the first die D1 from the first carrier C1.

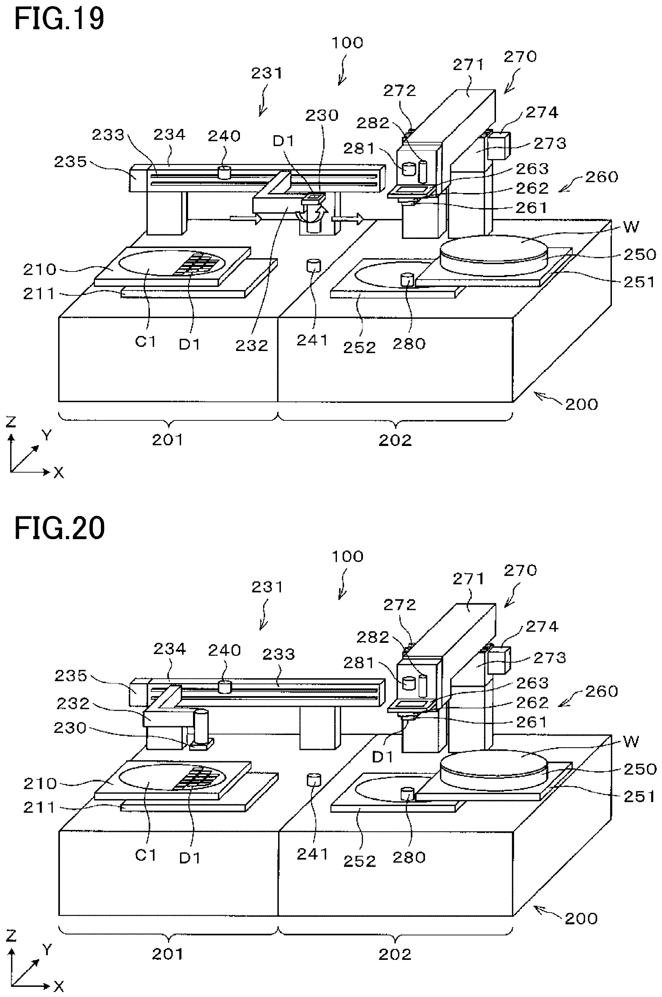

Next, as illustrated in FIG. 19, the collet 230 is moved in the positive direction of the X-axis to the upper side of the second imaging unit 241. The second imaging unit 241 captures images of at least two points of the first die D1 held by the collet 230. The captured images are output to the control device 140, and the control device 140 measures the position of the first die D1 held by the collet 230. The control device 140 controls the moving mechanism 231 based on the measured position of the first die D1 and adjusts the position of the collet 230, so that the collet 230 transfers the first die D1 to the central portion of the bond head 261.

Next, the collet 230 is rotated around the horizontal axis (around the X axis), thereby reversing the front and rear surfaces of the first die D1. Then, the rear surface D1b of the first die D1 held by the collet 230 is turned upward.

Next, the collet 230 is further moved in the positive direction of the X axis, and moved below the bond head 261. Subsequently, the collet 230 transfers the first die D1 to the bond head 261. The first die D1 is disposed at the central portion of the bond head 261.

Next, as illustrated in FIG. 20, the third imaging unit 280 captures images of at least two points of the first die D1 held by the bond head 261. The captured images are output to the control device 140, and the control device 140 measures the position of the first die D1 held by the bond head 261.

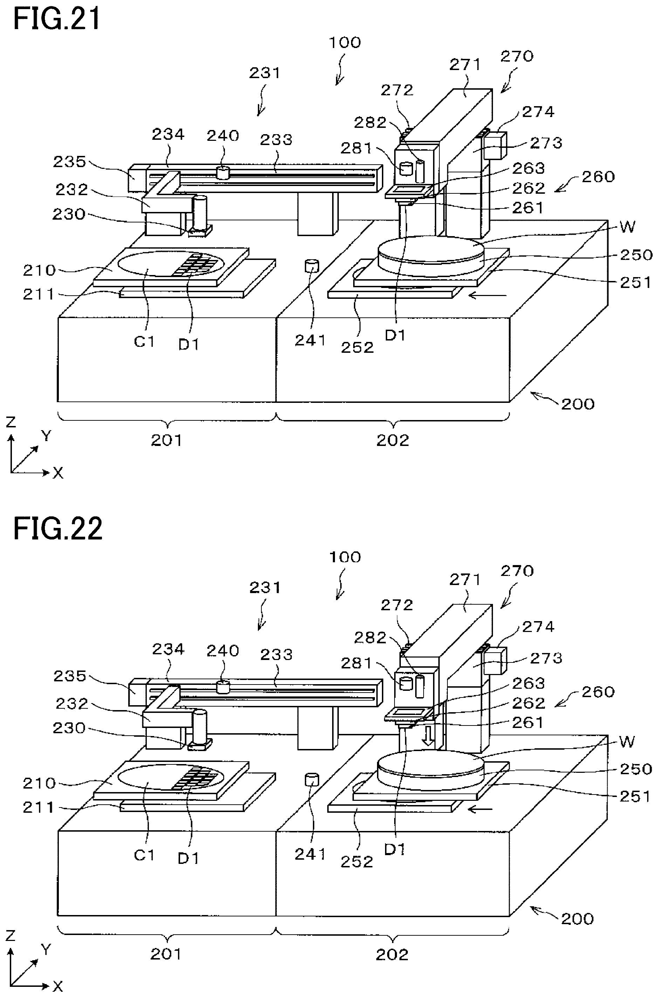

Next, as illustrated in FIG. 21, the wafer holder 250 is moved below the bond head 261 (the fourth imaging unit 281). Subsequently, the fourth imaging unit 281 captures images of at least two points of the wafer W held by the wafer holder 250. The captured images are output to the control device 140, and the control device 140 measures the position of the wafer W held by the wafer W. The control device 140 adjusts the position of the first die D1 relative to the wafer W based on the position of the first die D1 measured using the third imaging unit 280 and the position of the wafer W measured using the fourth imaging unit 281, so that the first die D1 is bonded at an appropriate position of the wafer W.

Next, as illustrated in FIG. 22, the bond head 261 is lowered so that the surface D1a of the first die D1 held by the bond head 261 overlaps the surface Wa of the wafer W, and the first die D1 is pressed against the wafer W for bonding. Subsequently, the bond head 261 is elevated.

Herein, as described above, the holding surface (lower surface) of the first die D1 in the bond head 261 has a convex shape with a central portion protruding downward. For example, if the first die D1 is held at a position offset from the central portion of the bond head 261, and the first die D1 is pressed against the wafer W, the uniformity of the contact pressure between the first die D1 and the wafer W deteriorates, which may result in the formation of a void between the wafer W and the first die D1. In this regard, in the present embodiment, since the position of the collet 230 is adjusted based on the images of the first die D1 captured by the second imaging unit 241, the first die D1 is appropriately held at the central portion of the bond head 261. For this reason, when the first die D1 is bonded to the wafer W, the uniformity of the contact pressure between the first die D1 and the wafer W can be improved, and the formation of voids can be suppressed.

The operation of bonding the first die D1 to the wafer W is performed in the above-described manner. The bonding operation of the first die D1 is performed independently and continuously for each of the plurality of first dies D1 attracted to and held on the first carrier C1.

After the first dies D1 are bonded at respective desired positions of the wafer W, the fifth imaging unit 282 captures an image of the first dies D1 mounted on the wafer W from above. The captured image is output to the control device 140, and the control device 140 measures the positions of the first dies D1 relative to the wafer W to check the accuracy of bonding of the first dies D1 with respect to the wafer W. Thus, a series of bonding processes in the first bonding apparatus 100 is completed.

According to the above-described embodiment, various position adjustments (alignment) are performed in the first bonding apparatus 100. In other words, the positions of the collet 230 and the first die D1 picked up by the collet 230 are adjusted using the first imaging unit 240. The position of the collet 230 is adjusted using the second imaging unit 241, so that the collet 230 transfers the first die D1 to the central portion of the bond head 261. The position of the first die D1 relative to the wafer W is adjusted using the third imaging unit 280 and the fourth imaging unit 281. Therefore, the first die D1 can be bonded to the wafer W at an appropriate position. In addition, the formation of voids, which tends to occur when the first die D1 is bonded to the wafer W, can be suppressed. Therefore, the first bonding apparatus 100 can bond the first die D1 to the wafer W with high accuracy of bonding.

In the first bonding apparatus 100, by increasing the rigidity of the moving mechanism 211, the rigidity of the arm 232 of the moving mechanism 231, the rigidity of the moving mechanism 252, and the rigidity of the arm 271 of the moving mechanism 270, the movement of the carrier holder 210, the movement of the collet 230, the movement of the wafer holder 250, and the movement of the head unit 260 can be made highly accurate. In this case, the accuracy of bonding of the first dies D1 with respect to the wafer W in the first bonding apparatus 100 can be improved.

In the first bonding apparatus 100, by improving the performance of the driving part of the moving mechanism 211, the driving part 235 of the moving mechanism 231, the driving part of the moving mechanism 252, and the driving part 274 of the moving mechanism 231, it is possible to speed up the movement of the carrier holder 210, the movement of the collet 230, the movement of the wafer holder 250, and the movement of the head unit 260. Therefore, the time required for the bonding process in the first bonding apparatus 100 can be shortened.

Next, the configuration of the second bonding apparatus 130 will be described focusing on differences from the first bonding apparatus 100. The second bonding apparatus 130 is a low-accuracy bonding apparatus, and the apparatus configuration can be reduced to a low-accuracy specification as compared with the first bonding apparatus 100.

For example, in the second bonding apparatus 130, at least one of the first imaging unit 240, the third imaging unit 280, and the fourth imaging unit 281 can be omitted because the positional accuracy of the second dies D2 with respect to the wafer W can be reduced. The second imaging unit 241 can be omitted if it is not necessary to suppress voids when bonding the second dies D2 to the wafer W. Furthermore, the fifth imaging unit 282 can be omitted because the accuracy of bonding of the second dies D2 with respect to the wafer W can be reduced and inspection is unnecessary.

In the second bonding apparatus 130, by improving the performance of the driving part of the moving mechanism 211, the driving part 235 of the moving mechanism 231, the driving part of the moving mechanism 252, and the driving part 274 of the moving mechanism 270, it is possible to speed up the movement of the carrier holder 210, the movement of the collet 230, the movement of the wafer holder 250, and the movement of the head unit 260. On the other hand, since the higher performance of each of the driving parts increases the size of the driving part, it is preferable to reduce the rigidity of the moving mechanism 211, the rigidity of the arm 232 of the moving mechanism 231, the rigidity of the moving mechanism 252, and the rigidity of the arm 271 of the moving mechanism 270, respectively. In this regard, since the accuracy of bonding required for the second bonding apparatus 130 is low, it is possible to reduce the rigidity.

As described above, the apparatus configuration of the second bonding apparatus 130 can be reduced to a low-accuracy specification and the bonding conditions can be further reduced to a low-accuracy specification as compared with the first bonding apparatus 100. Therefore, the time required for the bonding process in the second bonding apparatus 130 can be reduced. The second bonding apparatus 130 can include the same apparatus configuration as the first bonding apparatus 100, and only the bonding conditions can be reduced to a low-accuracy specification.

The bonding conditions are conditions for bonding the first dies D1 and the second dies D2 to the wafer W and are apparatus parameters. The apparatus parameters are, for example, the acceleration/deceleration and speed of the movement of the carrier holder 210, the collet 230, the wafer holder 250, and the head unit 260 by the moving mechanisms 211, 231, 252, and 270, and the waiting time until the driving parts of the moving mechanisms 211, 231, 252, and 270 are stabilized. The device parameters are whether or not imaging is performed by the imaging units 240, 241, 280, 281, and 282 and imaging time.

In the first bonding apparatus 100 and the second bonding apparatus 130 of the above embodiments, the separation region 201 and the bonding region 202 are arranged side by side in the horizontal direction (the positive direction of the X-axis), but they may be stacked in the vertical direction, for example. In this case, the footprint (occupied area) of the first bonding apparatus 100 and the second bonding apparatus 130 can be reduced.

Although the first carrier C1 holds a plurality of first dies D1 and the second carrier C2 holds a plurality of second dies D2 in the foregoing embodiment, one carrier may hold a plurality of first dies D1 and a plurality of second dies D2. Alternatively, as described later, one carrier may hold three or more types of dies, and the pattern of dies held by one carrier may be freely determined.

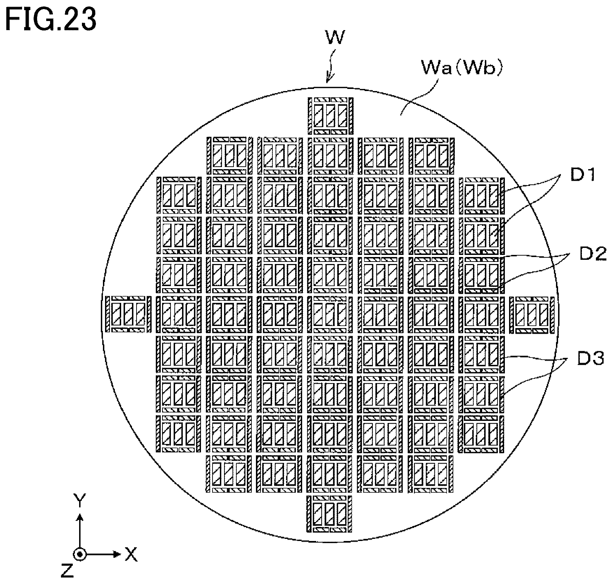

In the foregoing embodiment, the case where the first dies D1 and the second dies D2 are mounted on the wafer W has been described, but there is a case where three or more types of dies are mounted on the wafer W. For example, as illustrated in FIG. 23, third dies D3 are mounted on the wafer W in addition to the first dies D1 and the second dies D2. In this case, the processing system 1 may be provided with a dedicated bonding apparatus (not illustrated) configured to bond the third dies D3 to the wafer W. Alternatively, for example, when the third dies D3 is a low-accuracy die, the second dies D2 and the third dies D3 may be bonded to the wafer W by replacing the bond head 261 in the second bonding apparatus 130.

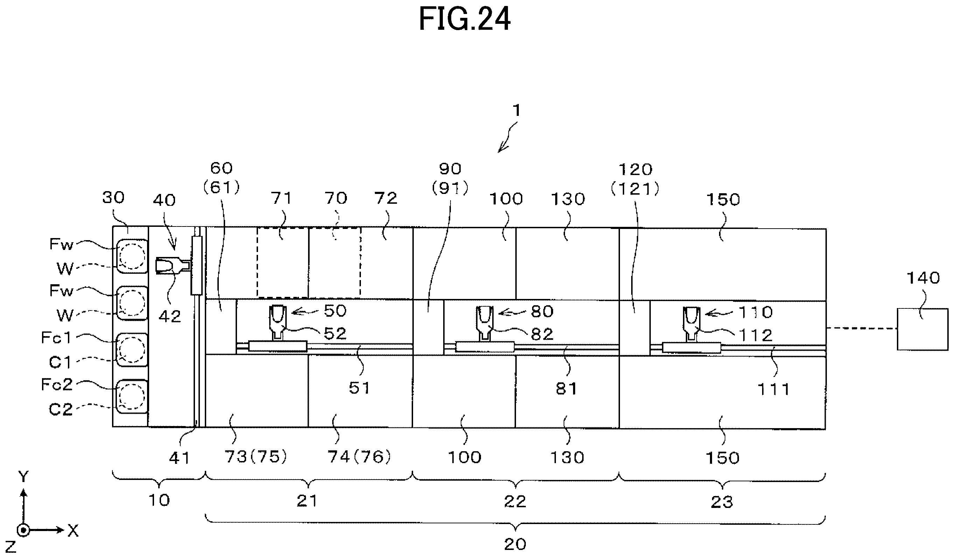

In the processing system 1 of the above embodiments, the multiple types of the bonding apparatuses may be discretionarily configured. For example, the processing system 1 may include a plurality of bonding apparatuses configured to bond a single type of die to the wafer W, or a plurality of bonding apparatuses configured to bond multiple types of dies to the wafer W. Alternatively, for example, as illustrated in FIG. 24, the processing system 1 may include a third bonding apparatus 150 in addition to the first bonding apparatus 100 and the second bonding apparatus 130. The third bonding apparatus 150 is configured to accommodate, for example, two wafers W, and bonds dies to these wafers W. In this case, the throughput of the die-on-wafer manufacturing process can be improved.

As described above, the bonding apparatus of another embodiment may be configured to bond multiple types of dies D ("dies D" herein is a general term referring to the dies D1 and dies D2 of different types) to the wafer W, and in this case, it is necessary to replace the bond head 261. Hereinafter, a configuration of the bonding apparatus 300 and a method of replacing the bond head 261 will be described.

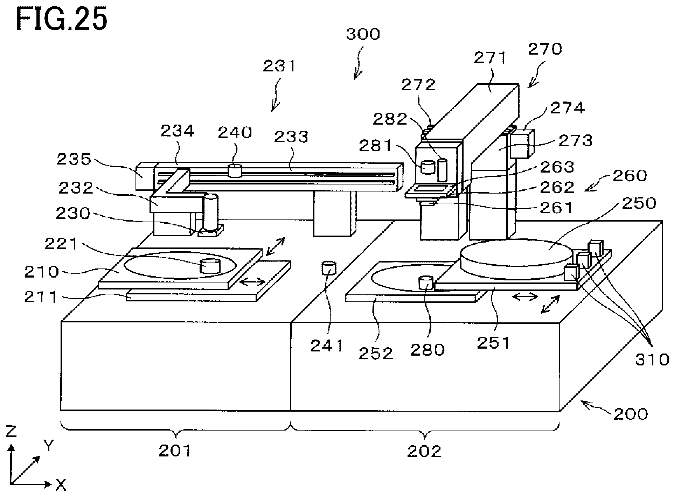

As illustrated in FIG. 25, the bonding apparatus 300 includes a plurality of, for example, three bond head mounting tables 310 in addition to the components of the first bonding apparatus 100 described above. The plurality of bond head mounting tables 310 are arranged on the support plate 251 in the positive direction of the X-axis of the wafer holder 250. In other words, the plurality of bond head mounting tables 310 are configured to move integrally with the wafer holder 250 by the moving mechanism 252. The upper surfaces (mounting surfaces) of the bond head mounting tables 310 are located at the same height as the upper surface (holding surface) of the wafer holder 250. The number of the bond head mounting tables 310 is freely determined, and may be two, or four or more, for example.

The bond head mounting tables 310 are configured in such a manner that the bond head 261 is mounted thereon. In the present embodiment, for example, the bond head 261 for replacement is mounted on two bond head mounting tables 310, and a single bond head mounting table 310 is empty and does not mount the bond head 261.

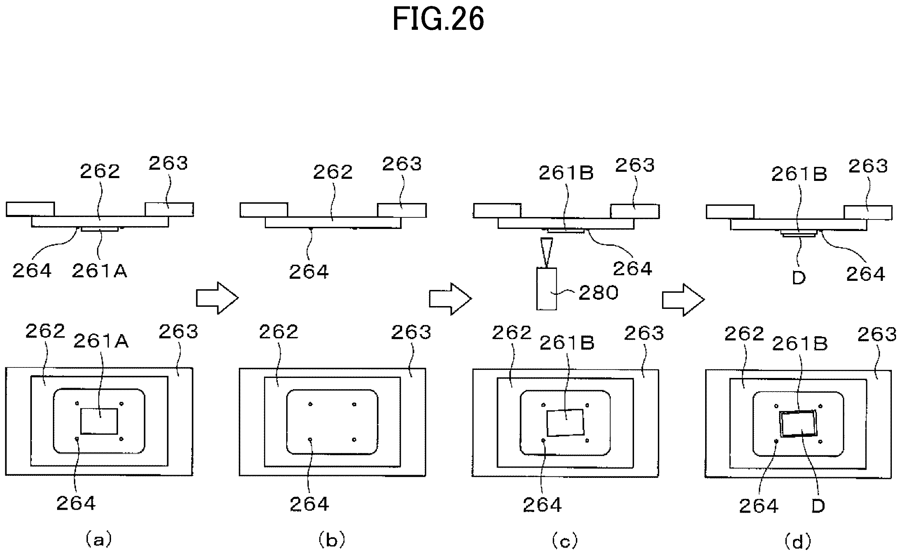

A case where a bond head 261A is replaced with a bond head 261B in the above-described bonding apparatus 300 will be described. First, as illustrated in FIG. 26(a), an empty bond head mounting table 310 is moved to a position below the bond head 261A held by the glass plate 262.

Next, the bond head 261A is lowered and mounted on the bond head mounting table 310. Subsequently, vacuum suction of the bond head 261A is terminated, and the bond head 261A is transferred to the bond head mounting table 310. In other words, the bond head 261A is no longer held by the glass plate 262 as illustrated in FIG. 26(b).

Next, the bond head mounting table 310 on which the bond head 261B is mounted is moved below the glass plate 262. Subsequently, the bond head 261B is attracted and held by the glass plate 262 by vacuum suction as illustrated in FIG. 26(c). Then, the bond head 261B is elevated to complete the replacement of the bond head 261A with the bond head 261B.

When the bond head 261A is replaced with the bond head 261B, the bond head 261B may be held at a position offset from a desired position with respect to the glass plate 262 as illustrated in FIG. 26(c). When the die D is held by the bond head 261B in this state, the die D may be held at a position offset from the central portion of the bond head 261B. This case may result in the formation of a void between the wafer W and the die D when the die D is bonded to the wafer W.

For this reason, conventionally, after the die D is held by the bond head 261B, an image of the die D is captured by the third imaging unit 280, and the amount of positional deviation of the die D with respect to the bond head 261B is measured in the control device 140. Then, based on the measured amount of positional deviation, the position of the die D is corrected so that the die D is held at the central portion of the bond head 261B when the second or subsequent die D is transferred from the collet 230 to the bond head 261B.

However, when the position of the die D relative to the bond head 261B is corrected using the conventional method, the position of the die D that is held by the bond head 261B second and thereafter can be corrected, but the position of the die D that is held by the bond head 261B first cannot be corrected. Furthermore, in order for the third imaging unit 280 to measure the amount of positional deviation of the die D relative to the bond head 261B, the bond head 261B must be larger than the die D.

For this reason, in the present embodiment, the bond head 261A is replaced with the bond head 261B as illustrated in FIG. 26(c), the bond head 261B is held by the glass plate 262 by vacuum suction, and then an image of the bond head 261B and at least two alignment marks 264 are captured by the third imaging unit 280. The captured image is output to the control device 140, and the control device 140 measures the position of the bond head 261B (for example, the edge of the bond head 261B) with respect to the alignment marks 264. In other words, the control device 140 measures the amount of positional deviation of the bond head 261B from a desired position of the bond head 261 with respect to the alignment marks 264.

Next, the control device 140 calculates the position of the die D with respect to the alignment marks 264 to hold the die D at the central portion of the bond head 261B based on the measured displacement of the bond head 261B. Then, the position of the collet 230 with respect to the bond head 261B is corrected when the die D is transferred from the collet 230 to the bond head 261B, and the position of the die D with respect to the bond head 261B is corrected as illustrated in FIG. 26(d). Then, the die D is held at the central portion of the bond head 261B.

According to the present embodiment, since the third imaging unit 280 captures an image of the alignment marks 264 and the bond head 261B, the bond head 261B does not need to be larger than the die D as in prior art. Then, since the position of the collet 230 with respect to the bond head 261B is corrected after the bond head 261B is replaced, the first die D can be held at the central portion of the bond head 261B. As a result, even when the first die D is bonded to the wafer W, formation of voids is suppressed and accuracy of bonding can be improved.

In the foregoing embodiment, the dies D1 and D2 held by the carriers C1 and C2 are mounted on the wafer W, but the carriers holding the dies D1 and D2 before mounting are not limited to the carriers C1 and C2 of the foregoing embodiment. For example, the dies D1 and D2 may be attached to a dicing tape fixed to a dicing frame. The silicon layers S1 and S2 on the rear surfaces D1b and D2b of the dies D1 and D2 are attached to the dicing tape.

The embodiments disclosed herein should be considered exemplary and not restrictive in all respects. The above embodiments may be omitted, substituted or altered in various ways without departing from the scope and gist of the appended claims. For example, the configuration requirements of the above embodiments may be combined as appropriate. Such freely chosen combinations will naturally provide the operations and effects of the respective configuration requirements of the combination, as well as other operations and effects apparent to those skilled in the art from the description herein.

The effects described herein are merely illustrative or exemplary and are not limiting. In other words, the techniques of the present disclosure may produce other effects that are apparent to those skilled in the art from the description herein, in addition to or in place of the above effects.

### REFERENCE SIGNS LIST

- 1: Processing system
- 100: First bonding apparatus
- 130: Second bonding apparatus
- C1: First carrier
- C2: Second carrier
- D1: First die
- D2: Second die
- W: Wafer

## Claims

1. A processing system for mounting dies of multiple types on a target substrate, the processing system comprising:
bonding apparatuses of multiple types each configured to bond a die held by a carrier to the target substrate, wherein
the bonding apparatuses of multiple types differ in accuracy of bonding of the dies with respect to the target substrate.

2. The processing system according to claim 1, wherein
a bonding apparatus having a relatively high accuracy of bonding and a bonding apparatus having a relatively low accuracy of bonding among the bonding apparatuses of multiple types differ in at least one of a specification of a moving mechanism for the dies or a specification of a position adjusting mechanism for the dies.

3. The processing system according to claim 2, wherein
each of the bonding apparatuses includes
a carrier holder configured to hold the carrier;
a substrate holder configured to hold the target substrate;
a collet configured to pick up and transfer the die from the carrier; and
a head configured to receive the die from the collet and transfer the die to the target substrate, and
the moving mechanism includes the collet and the head.

4. The processing system according to claim 2, wherein
each of the bonding apparatuses includes
a carrier holder configured to hold the carrier;
a substrate holder configured to hold the target substrate;
a collet configured to pick up and transfer the die from the carrier; and
a head configured to receive the die from the collet and transfer the die to the target substrate, and
the position adjusting mechanism is configured to adjust a relative position between the die held by the head and the target substrate held by the substrate holder.

5. The processing system according to claim 1, wherein
a bonding apparatus having a relatively high accuracy of bonding and a bonding apparatus having a relatively low accuracy of bonding among the bonding apparatuses of multiple types have different bonding conditions for bonding the dies to the target substrate.

6. The processing system according to claim 1, wherein
a circuit is formed in the die bonded by a bonding apparatus having a relatively high accuracy of bonding among the bonding apparatuses of multiple types, and
a circuit is not formed in the die bonded by a bonding apparatus having a relatively low accuracy of bonding among the bonding apparatuses of multiple types.

7. The processing system according to claim 1, wherein
the die bonded by a bonding apparatus having a relatively high accuracy of bonding among the bonding apparatuses of multiple types has a different shape from the die bonded by a bonding apparatus having a relatively low accuracy of bonding among the bonding apparatuses of multiple types.

8. The processing system according to claim 1, wherein
the carrier includes a main body having a plurality of through-holes formed in a thickness direction.

9. The processing system according to claim 1, further comprising
a die surface cleaning device configured to clean a surface of the die held by the carrier;
a die surface modifying device configured to modify the surface of the die held by the carrier;
a die surface hydrophilizing device configured to hydrophilize the surface of the die held by the carrier;
a substrate surface cleaning device configured to clean a surface of the target substrate;
a substrate surface modifying device configured to modify the surface of the target substrate; and
a substrate surface hydrophilizing device configured to hydrophilize the surface of the target substrate.

10. A processing method for mounting dies of multiple types on a target substrate, the processing method comprising:
bonding a die held by a carrier to the target substrate using bonding apparatuses of multiple types, wherein
accuracy of bonding of the dies with respect to the target substrate differs between the bonding apparatuses of multiple types.

11. The processing method according to claim 10, wherein
a bonding apparatus having a relatively high accuracy of bonding and a bonding apparatus having a relatively low accuracy of bonding among the bonding apparatuses of multiple types differ in at least one of a specification of a moving mechanism for the dies or a specification of a position adjusting mechanism for the dies.

12. The processing method according to claim 10, wherein
a bonding apparatus having a relatively high accuracy of bonding and a bonding apparatus having a relatively low accuracy of bonding among the bonding apparatuses of multiple types have different bonding conditions for bonding the dies to the target substrate.

13. The processing method according to claim 10, wherein
a circuit is formed in the die bonded by a bonding apparatus having a relatively high accuracy of bonding among the bonding apparatuses of multiple types, and
a circuit is not formed in the die bonded by a bonding apparatus having a relatively low accuracy of bonding among the bonding apparatuses of multiple types.

14. The processing method according to claim 10, wherein
a die bonded by a bonding apparatus having a relatively high accuracy of bonding among the bonding apparatuses of multiple types has a different shape from a die bonded by a bonding apparatus having a relatively low accuracy of bonding among the bonding apparatuses of multiple types.

15. The processing method according to claim 10, wherein
the carrier includes a main body having a plurality of through-holes formed in a thickness direction, and
air is supplied to the die through the through-holes when the die is picked up from the carrier in a bonding apparatus among the bonding apparatuses of multiple types.

16. The processing method according to claim 10, comprising:
cleaning, by a die surface cleaning device, a surface of the die held by the carrier;
modifying, by a die surface modifying device, the surface of the die held by the carrier;
hydrophilizing, by a die surface hydrophilizing device, the surface of the die held by the carrier;
cleaning, by a substrate surface cleaning device, a surface of the target substrate;
modifying, by a substrate surface modifying device, the surface of the target substrate; and
hydrophilizing, by a substrate surface hydrophilizing device, the surface of the target substrate.
